# EUROPEAN PATENT APPLICATION

(11) **EP 4 791 004 A1**
(43) Date of publication of application: **12.08.2026**
(21) Application number: 24881445.1
(22) Date of filing: 12.10.2024
(51) Int. Cl.: H04N 19/93

(54) **ENCODING METHOD AND APPARATUS, DECODING METHOD AND APPARATUS, DEVICE AND STORAGE MEDIUM**

(30) Priority: 27.10.2023 CN 202311421118
(71) Applicant: HUAWEI TECHNOLOGIES CO., LTD., Shenzhen, Guangdong 518129 (CN)
(72) Inventor: PENG, Xutan, Shenzhen, Guangdong 518129 (CN); PENG, Dejia, Shenzhen, Guangdong 518129 (CN); ZHU, Jiafa, Shenzhen, Guangdong 518129 (CN); CHEN, Yong, Shenzhen, Guangdong 518129 (CN); HU, Xuebing, Shenzhen, Guangdong 518129 (CN)
(74) Representative: Isarpatent
(86) International application number: PCT/CN2024/124433
(87) International publication number: WO 2025/087079

(57) **Abstract**

This application discloses an encoding method and apparatus, a decoding method and apparatus, a device, and a storage medium, and pertains to the field of encoding and decoding technologies. In the encoding method, a data set is obtained, where the data set includes N pieces of data, and N is greater than or equal to 2 (201). If an occurrence frequency of first data of the N pieces of data in the N pieces of data is greater than or equal to a reference threshold, RLE is performed on the first data (202). The reference threshold is determined based on N, a quantity of bit occupied by a first element, and a quantity of bit occupied by a second element, the first element is determined based on the first data, and the second element is a consecutive occurrence count of the first data. In this application, the first data suitable for performing RLE is quickly and accurately determined from the N pieces of data based on a reference threshold with low computational complexity. Therefore, RLE is performed only on the first data that is suitable for performing RLE in the N pieces of data. The manner of performing RLE is reasonable, avoiding unnecessary computational overheads and encoding overheads, and improving encoding efficiency.

## Description

This application claims priority to Chinese Patent Application No. 202311421118.7, filed on October 27, 2023 and entitled "ENCODING METHOD AND APPARATUS, DECODING METHOD AND APPARATUS, DEVICE, AND STORAGE MEDIUM", which is incorporated herein by reference in its entirety.

### TECHNICAL FIELD

This application relates to the field of encoding and decoding technologies, and in particular, to an encoding method and apparatus, a decoding method and apparatus, a device, and a storage medium.

### BACKGROUND

With continuous development of encoding and decoding technologies, there are increasingly more manners for encoding and decoding data, and run-length encoding (run-length encoding, RLE) and a corresponding decoding manner are one of the manners. How to perform proper RLE and corresponding decoding on data becomes an urgent problem to be resolved.

### SUMMARY

This application provides an encoding method and apparatus, a decoding method and apparatus, a device, and a storage medium, to perform proper RLE and corresponding decoding on data. The technical solutions provided in this application include the following aspects.

According to a first aspect, an encoding method is provided. In the method, a data set is obtained, where the data set includes N pieces of data, and N is greater than or equal to 2. If an occurrence frequency of first data of the N pieces of data in the N pieces of data is greater than or equal to a reference threshold, RLE is performed on the first data. The reference threshold is determined based on N, a bit occupied by a first element, and a bit occupied by a second element, the first element is determined based on the first data, and the second element is a consecutive occurrence count of the first data.

In the method, the first data that is suitable for performing RLE is determined from the N pieces of data based on the reference threshold. In this way, RLE is performed only on the first data that is suitable for performing RLE, thereby implementing proper RLE and avoiding unnecessary encoding overheads. In addition, because the reference threshold is determined based on N, the bit occupied by the first element, and the bit occupied by the second element, and N, the bit occupied by the first element, and the bit occupied by the second element are all constants that can be easily determined, computational complexity for determining the reference threshold is low, and the first data that is suitable for performing RLE can be quickly and accurately determined based on the reference threshold. Therefore, not only is deterioration after RLE avoided, but computational overheads are also reduced, further improving encoding efficiency.

In a possible implementation, the reference threshold is determined based on a ratio of a first value to a second value, the first value is a product of the bit occupied by the second element and N, and the second value is a sum of the bit occupied by the first element and the bit occupied by the second element.

In this implementation, the reference threshold is determined by determining the ratio based on the product and the sum. This determining manner is simple and easy to implement, has low computational overheads, and has high practicability.

In a possible implementation, the method further includes: encoding second data in the N pieces of data other than the first data, to obtain an encoding result. The encoding result includes the first element, the second element, a third element, and a fourth element. The third element is determined based on the second data. An arrangement manner of the third element and the first element in the encoding result is the same as an arrangement manner of the second data and the first data in the N pieces of data. The fourth element is determined based on the first data.

The second data is data that is not suitable for performing RLE. If the second data in the N pieces of data further exists in addition to the first data, the second data needs to be encoded in a non-RLE manner, to obtain the encoding result. Because the first element is determined based on the first data, and the third element is determined based on the second data, the arrangement manner of the second data and the first data in the N pieces of data can be naturally reflected according to the arrangement manner of the third element and the first element in the encoding result, to facilitate subsequent decoding of the encoding result. However, because the third element and the first element are arranged together in a specific arrangement manner, it is difficult to distinguish the third element and the first element from the third element and the first element that are arranged together during decoding. Therefore, the fourth element further needs to be determined based on the first data, to distinguish the third element from the first element. During decoding, for any one of the third element and the first element that are arranged together, if the element also belongs to the fourth element, it indicates that the element is the first element determined based on the first data; or if the element does not belong to the fourth element, it indicates that the element is the third element determined based on the second data.

In a possible implementation, the method further includes: encoding second data in the N pieces of data other than the first data, to obtain an encoding result. The encoding result includes the first element, the second element, a fifth element, and a sixth element, the fifth element is determined based on the second data, and the sixth element indicates an arrangement manner of the second data and the first data in the N pieces of data.

As described above, the second data is data that is not suitable for performing RLE. When the second data exists in the N pieces of data in addition to the first data, the second data needs to be encoded in a non-RLE manner, to obtain the encoding result. The first element determined based on the first data and the fifth element determined based on the second data are independent of each other. Therefore, the first element and the fifth element do not need to be distinguished. However, because the first element and the fifth element are independent of each other, it is difficult to determine an arrangement order of the first element and the fifth element during subsequent decoding. Therefore, although the first data and the second data can be obtained through decoding, it is difficult to arrange, according to the arrangement manner of the first data and the second data in the N pieces of data, the first data and the second data that are obtained through decoding, and therefore, it is difficult to restore the N pieces of data. Therefore, the sixth element further needs to be used, to indicate an arrangement manner of the second data and the first data in the N pieces of data, to subsequently complete decoding.

In a possible implementation, the second element occupies 2^{M} bits, and M is greater than or equal to 1.

For example, the bit occupied by the second element may be 4 bits, 8 bits, or the like. In this application, M tends to have a relatively small value, so that more space can be saved after RLE is performed on the first data.

According to a second aspect, a decoding method is provided. In the method, after an encoding result is obtained, the encoding result is decoded. The encoding result is obtained by performing RLE on first data in the N pieces of data included in a data set, where N is greater than or equal to 2, an occurrence frequency of the first data in the N pieces of data is greater than or equal to a reference threshold, the reference threshold is determined based on N, a bit occupied by a first element, and a bit occupied by a second element, the first element is determined based on the first data, and the second element is a consecutive occurrence count of the first data.

In a possible implementation, the reference threshold is determined based on a ratio of a first value to a second value, the first value is a product of the bit occupied by the second element and N, and the second value is a sum of the bit occupied by the first element and the bit occupied by the second element.

In a possible implementation, the encoding result is further obtained by encoding second data in the N pieces of data other than the first data. The encoding result includes the first element, the second element, a third element, and a fourth element. The third element is determined based on the second data. An arrangement manner of the third element and the first element in the encoding result is the same as an arrangement manner of the second data and the first data in the N pieces of data. The fourth element is determined based on the first data. Decoding the encoding result includes: decoding the first element and the third element based on the second element and the fourth element.

In a possible implementation, the encoding result is further obtained by encoding second data in the N pieces of data other than the first data, the encoding result includes the first element, the second element, a fifth element, and a sixth element, the fifth element is determined based on the second data, and the sixth element indicates an arrangement manner of the second data and the first data in the N pieces of data. Decoding the encoding result includes: decoding the first element and the fifth element based on the second element and the sixth element.

In a possible implementation, the second element occupies 2^{M} bits, and M is greater than or equal to 1.

According to a third aspect, an encoding apparatus is provided. The apparatus includes:
an obtaining module, configured to obtain a data set, where the data set includes N pieces of data, and N is greater than or equal to 2; and
an encoding module, configured to: if an occurrence frequency of first data of the N pieces of data in the N pieces of data is greater than or equal to a reference threshold, perform RLE on the first data, where
the reference threshold is determined based on N, a bit occupied by a first element, and a bit occupied by a second element, the first element is determined based on the first data, and the second element is a consecutive occurrence count of the first data.

In a possible implementation, the reference threshold is determined based on a ratio of a first value to a second value, the first value is a product of the bit occupied by the second element and N, and the second value is a sum of the bit occupied by the first element and the bit occupied by the second element.

In a possible implementation, the encoding module is further configured to encode second data in the N pieces of data other than the first data, to obtain an encoding result, where the encoding result includes the first element, the second element, a third element, and a fourth element, the third element is determined based on the second data, an arrangement manner of the third element and the first element in the encoding result is the same as an arrangement manner of the second data and the first data in the N pieces of data, and the fourth element is determined based on the first data.

In a possible implementation, the encoding module is further configured to encode second data in the N pieces of data other than the first data, to obtain an encoding result, where the encoding result includes the first element, the second element, a fifth element, and a sixth element, the fifth element is determined based on the second data, and the sixth element indicates an arrangement manner of the second data and the first data in the N pieces of data.

In a possible implementation, the second element occupies 2^{M} bits, and M is greater than or equal to 1.

According to a fourth aspect, a decoding apparatus is provided. The apparatus includes:
an obtaining module, configured to obtain an encoding result, where the encoding result is obtained by performing RLE on first data in N pieces of data included in a data set, N is greater than or equal to 2, an occurrence frequency of the first data in the N pieces of data is greater than or equal to a reference threshold, the reference threshold is determined based on N, a bit occupied by a first element, and a bit occupied by a second element, the first element is determined based on the first data, and the second element is a consecutive occurrence count of the first data; and
a decoding module, configured to decode the encoding result.

In a possible implementation, the reference threshold is determined based on a ratio of a first value to a second value, the first value is a product of the bit occupied by the second element and N, and the second value is a sum of the bit occupied by the first element and the bit occupied by the second element.

In a possible implementation, the encoding result is further obtained by encoding second data in the N pieces of data other than the first data, the encoding result includes the first element, the second element, a third element, and a fourth element, the third element is determined based on the second data, an arrangement manner of the third element and the first element in the encoding result is the same as an arrangement manner of the second data and the first data in the N pieces of data, and the fourth element is determined based on the first data; and the decoding module is configured to decode the first element and the third element based on the second element and the fourth element.

In a possible implementation, the encoding result is further obtained by encoding second data in the N pieces of data other than the first data, the encoding result includes the first element, the second element, a fifth element, and a sixth element, the fifth element is determined based on the second data, and the sixth element indicates an arrangement manner of the second data and the first data in the N pieces of data; and the decoding module is configured to decode the first element and the fifth element based on the second element and the sixth element.

In a possible implementation, the second element occupies 2^{M} bits, and M is greater than or equal to 1.

According to a fifth aspect, a computer device is provided. The device includes a memory and a processor. The memory stores at least one computer instruction, and the at least one computer instruction is loaded and executed by the processor, so that the computer device implements the encoding method provided in any one of the first aspect or the possible implementations of the first aspect, or implements the decoding method provided in any one of the second aspect or the possible implementations of the second aspect.

Optionally, there are one or more processors, and there are one or more memories.

Optionally, the memory and the processor may be integrated together, or the memory and the processor may be separately disposed.

According to a sixth aspect, an encoding and decoding system is provided. The system includes an encoder and a decoder. The encoder is configured to perform the encoding method provided in any one of the first aspect or the possible implementations of the first aspect, and the decoder is configured to perform the decoding method provided in any one of the second aspect or the possible implementations of the second aspect.

According to a seventh aspect, a computer program or a computer program product is provided. The computer program or the computer program product includes computer instructions. When the computer instructions are run by a computer, the computer is enabled to implement the encoding method provided in any one of the first aspect or the possible implementations of the first aspect, or implement the decoding method provided in any one of the second aspect or the possible implementations of the second aspect.

According to an eighth aspect, a computer-readable storage medium is provided. The computer-readable storage medium stores computer instructions. When the computer instructions are run on a computer, the computer performs the encoding method provided in any one of the first aspect or the possible implementations of the first aspect, or implements the decoding method provided in any one of the second aspect or the possible implementations of the second aspect.

According to a ninth aspect, a chip is provided, including a processor, configured to invoke, from a memory, and run instructions stored in the memory, so that a computer in which the chip is installed performs the encoding method provided in any one of the first aspect or the possible implementations of the first aspect, or implements the decoding method provided in any one of the second aspect or the possible implementations of the second aspect.

According to a tenth aspect, another chip is provided, including an input interface, an output interface, a processor, and a memory. The input interface, the output interface, the processor, and the memory are connected through an internal connection path. The processor is configured to execute code in the memory. When the code is executed, a computer in which the chip is installed performs the encoding method provided in any one of the first aspect or the possible implementations of the first aspect, or implements the decoding method provided in any one of the second aspect or the possible implementations of the second aspect.

It should be understood that, for technical effects achieved by the technical solutions provided in the second aspect to the tenth aspect and the corresponding possible implementations of this application, refer to technical effects of the technical solution provided in the first aspect and the corresponding possible implementations. Details are not described herein again.

### BRIEF DESCRIPTION OF DRAWINGS

FIG. 1 is a diagram of an implementation environment according to an embodiment of this application;
FIG. 2 is a flowchart of an encoding method according to an embodiment of this application;
FIG. 3 is a schematic flowchart of an encoding method according to an embodiment of this application;
FIG. 4 is a schematic flowchart of another encoding method according to an embodiment of this application;
FIG. 5 is a diagram of a service scenario of image compression according to an embodiment of this application;
FIG. 6 is a diagram of a service scenario of a database according to an embodiment of this application;
FIG. 7 is a diagram of a service scenario of communication according to an embodiment of this application;
FIG. 8 is a flowchart of a decoding method according to an embodiment of this application;
FIG. 9 is a schematic flowchart of a decoding method according to an embodiment of this application;
FIG. 10 is a diagram of a reference sequence according to an embodiment of this application;
FIG. 11 is a diagram of a convergence trend according to an embodiment of this application;
FIG. 12A and FIG. 12B are diagrams of an impact caused by an error value according to an embodiment of this application;
FIG. 13 is a diagram of comparison between a measured result and a result obtained through calculation according to an embodiment of this application;
FIG. 14 is a diagram of a structure of an encoding apparatus according to an embodiment of this application;
FIG. 15 is a diagram of a structure of a decoding apparatus according to an embodiment of this application; and
FIG. 16 is a diagram of a structure of a computer device according to an embodiment of this application.

### DESCRIPTION OF EMBODIMENTS

Terms used in embodiments of this application are only used to explain specific embodiments of this application, but are not intended to limit this application.

Run-length encoding (run-length encoding, RLE) is an encoding method that can perform lossless compression on data, and is also referred to as variable-length encoding. A core idea of run-length encoding is to use a variable-length code to replace data that consecutively occurs (or repeatedly occurs) in a data sequence to be encoded. For example, if a to-be-encoded data sequence is [A, A, A, A, B, B, B, C, C, D, E, E, E, E, A, A], the data sequence may be encoded as [A, B, C, D, E, A] and [4, 3, 2, 1, 4, 2], or may be encoded as [A, 4, B, 3, C, 2, D, 1, E, 4, A, 2], to indicate that data A occurs four times consecutively, data B occurs three times consecutively, data C occurs twice consecutively, data D occurs once consecutively, data E occurs four times consecutively, and data A occurs twice consecutively.

For the foregoing RLE, there are a plurality of related technologies, including but not limited to the following related technology 1 to related technology 3.

### Related technology 1: simple RLE scheme

In the simple RLE scheme, the to-be-encoded data sequence is not analyzed, but RLE is performed on all data in the data sequence without distinction. However, when a consecutive occurrence count of the data in the data sequence is small, the simple RLE scheme not only brings extra encoding overheads, but may also cause a size expansion (namely, deterioration) of the data sequence, that is, a data amount of a variable-length code (used to replace the data sequence) may be caused to be greater than a data amount of the data sequence. For example, when a to-be-encoded data sequence is [A, B, C, D, E], the data sequence is encoded as [A, B, C, D, E] and [1, 1, 1, 1, 1]. Compared with the data sequence, [1, 1, 1, 1, 1] is added, causing deterioration.

### Related technology 2: static serial scheme and static parallel scheme

In the static serial scheme, RLE is used as a procedure of an encoding process based on experience, that is, RLE is used as an upstream or a downstream of another encoding method, and the another encoding method includes but is not limited to: Lempel Ziv 1977 (lempel ziv 1977, LZ77), simple 8-byte (simple 8-byte, Simple8b), GNU compression (GNU zip, GZIP), and the like. The GNU is a free operating system.

In the static parallel scheme, RLE is bound to a specific data segment (which may be considered as a data sequence to be encoded) based on experience, that is, RLE is performed only on the bound data segment, and RLE is not performed on another unbound data segment. For example, a database (data base, DB) stores data in a form of a table. In the table, one column includes modification dates of files, and another column includes names of the files. RLE is bound to the modification dates of the files, but not to the names of the files.

However, both the static serial scheme and the static parallel scheme are based on experience. If an actual data sequence does not match the experience, not only extra encoding overheads are brought, but also deterioration may occur even if RLE is performed only on the bound data segment.

### Related technology 3: adaptive selection scheme

In the adaptive selection scheme, a heuristic algorithm is designed based on experience and observation, and the heuristic algorithm is used to determine which data in a data sequence to be encoded is suitable for performing RLE, and RLE is performed only on the data suitable for performing RLE, but not on data not suitable for performing RLE.

However, because the heuristic algorithm is designed based only on experience and observation and lacks theoretical support, accuracy of determining performed by using the heuristic algorithm is low, and data that is actually not suitable for performing RLE may be determined as data suitable for performing RLE, that is, data that is incorrectly determined may occur. As a result, deterioration occurs after RLE is performed on the data that is incorrectly determined, and stability is poor. In addition, the heuristic algorithm has high computational complexity, and brings extra computational overheads in addition to encoding overheads, affecting encoding efficiency.

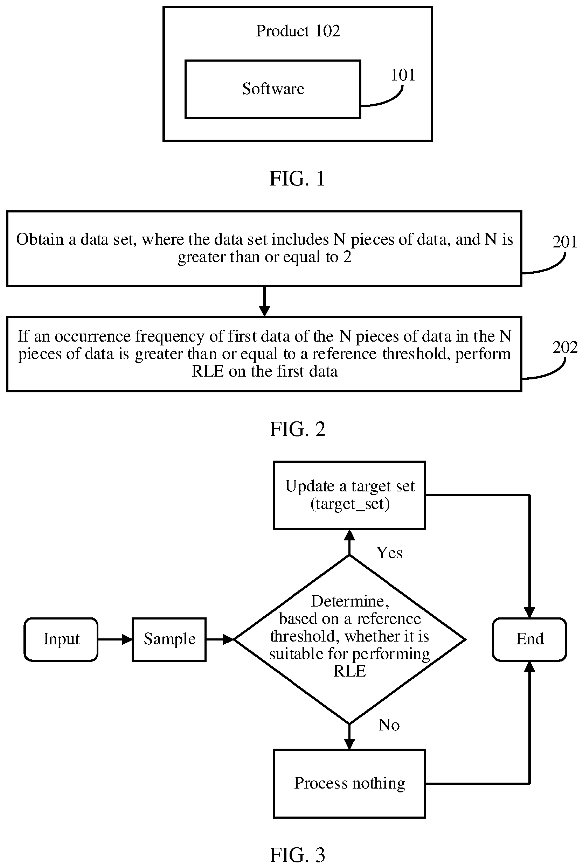

Therefore, an embodiment of this application provides an encoding method, and the encoding method is used to mitigate or resolve problems existing in the foregoing related technologies. For example, as shown in FIG. 1, the encoding method is applied to software 101, and the software 101 to which the encoding method is applied is deployed in a product 102. A function of the product includes but is not limited to an encoding function, or a data compression function. The product 102 used to deploy the software 101 may be in a form of software or may be in a form of hardware. This is not limited herein. As shown in FIG. 2, the encoding method includes the following step 201 and step 202.

Step 201: Obtain a data set, where the data set includes N pieces of data, and N is greater than or equal to 2.

The N pieces of data included in the data set are to-be-encoded data, and data that is different in the N pieces of data may have a same value or may have different values. In this embodiment of this application, data having a same value is used as same type of data, and the N pieces of data may include at least one type of data.

In some implementations, the N pieces of data are all to-be-encoded data. In this embodiment of this application, the N pieces of data may be obtained through receiving, or the N pieces of data may be obtained through generation. This is not limited herein. Alternatively, in some other implementations, the N pieces of data are a part of all to-be-encoded data, and the obtaining the N pieces of data includes: obtaining a plurality of pieces of data, and obtaining the N pieces of data by sampling the plurality of pieces of data. In the sampling process, a data amount can be reduced, that is, a data amount of the N pieces of data is less than a data amount of the plurality of pieces of data. In this case, computational overheads required for subsequent calculation that is based on the N pieces of data are small. Therefore, in this embodiment of this application, the N pieces of data may be obtained through sampling when computational power is limited. For example, a quantity threshold is determined based on computational power, so that a quantity of the N pieces of data obtained through sampling is less than or equal to the quantity threshold. Correspondingly, in this embodiment of this application, all the to-be-encoded data may be used as the N pieces of data when computational power is sufficient.

For example, the plurality of pieces of data may be all to-be-encoded data, and the plurality of pieces of data may be obtained through receiving or generation. Alternatively, the plurality of pieces of data may be a part of all to-be-encoded data. For example, all to-be-encoded data obtained through receiving or generation is divided into at least two groups, and the plurality of pieces of data are one group of data in the at least two groups of data.

In different service scenarios, manners of dividing all to-be-encoded data into at least two groups vary. For details, refer to the following three examples. In a service scenario of image compression, an image includes a plurality of pixels, each pixel corresponds to a plurality of color channels, and each pixel has a value on each color channel. Therefore, all to-be-encoded data includes a value of each pixel on each color channel. All the to-be-encoded data is divided based on the color channels to obtain a plurality of groups of data that are in one-to-one correspondence with the plurality of color channels, where each group of data is a value of each pixel in the image on a color channel corresponding to the group of data, a plurality of pieces of data are one group of data in the plurality of groups of data. Alternatively, in a service scenario of a database, the database stores data in a form of a table, and the table includes a plurality of rows and a plurality of columns. In this case, all to-be-encoded data includes all data stored in the table. All the to-be-encoded data is divided according to columns (or rows), to obtain a plurality of groups of data that are in one-to-one correspondence with each column (or each row), where each group of data is data stored in one column (or one row) included in the table, and a plurality of pieces of data are one group of data in the plurality of groups of data. Alternatively, in a service scenario of communication, a binary signal needs to be transmitted. The binary signal includes a plurality of bits, and a value of each bit is 0 or 1. In this case, all to-be-encoded data include a plurality of bits. All the to-be-encoded data is divided to obtain a plurality of groups of data, where each group of data includes a specific quantity of bits, and a plurality of pieces of data are one group of data in the plurality of groups of data. Certainly, a service scenario to which the encoding method provided in embodiments of this application is applicable is not limited to the service scenarios described above, and may further include another service scenario in which encoding needs to be performed. Details are not described herein by using examples one by one.

Regardless of the manner for obtaining the plurality of pieces of data, in this embodiment of this application, after the plurality of pieces of data are obtained, the plurality of pieces of data may be sampled, to obtain the N pieces of data. For example, the plurality of pieces of data may be randomly sampled. For another example, one piece of data may be collected from the plurality of pieces of data at an interval of a specific quantity of pieces of data. A sampling manner is not limited in embodiments of this application, and another sampling manner may also be applied to embodiments of this application based on an actual requirement. For example, another sampling manner may be flexibly used, so that each type of data in the plurality of pieces of data is sampled into the N pieces of data.

For example, in this embodiment of this application, step 201 and step 202 may be performed when all the to-be-encoded data is independent and identically distributed, and a quantity of all the to-be-encoded data is sufficient. For example, when the quantity of all the to-be-encoded data is greater than 1000, the quantity of all the to-be-encoded data is considered to be sufficient. In addition, the encoding method provided in this embodiment of this application may also be applied to a case in which all the to-be-encoded data meets another type of data distribution or has another quantity. This is not limited herein.

Step 202: If an occurrence frequency of first data of the N pieces of data in the N pieces of data is greater than or equal to a reference threshold, perform RLE on the first data.

It can be learned from the foregoing descriptions in step 201 that the data having the same value in the N pieces of data is the same type of data, and the reference threshold is a threshold used to determine whether various types of data in the N pieces of data are suitable for performing RLE. For each type of data in the N pieces of data, if an occurrence frequency of the type of data in the N pieces of data is greater than or equal to a reference threshold corresponding to the type of data, the type of data is first data suitable for performing RLE; or if an occurrence frequency of the type of data in the N pieces of data is less than the reference threshold corresponding to the type of data, the type of data is considered as data not suitable for performing RLE. Because the first data is suitable for performing RLE, RLE may be performed on the first data. An encoding result may be obtained by performing RLE on the first data, and that the first data is suitable for performing RLE may be quantified as follows: A data amount of the encoding result is less than or equal to a data amount of the first data, so that deterioration cannot occur after RLE is performed on the first data.

When the N pieces of data are all the to-be-encoded data, the performing RLE on the first data includes: performing RLE on the first data in the N pieces of data. Alternatively, when the N pieces of data are a part of all the to-be-encoded data, that is, when the N pieces of data are obtained by sampling the plurality of pieces of data, the performing RLE on the first data includes: performing RLE on the first data in the plurality of pieces of data. A reason is that the plurality of pieces of data further include other data in addition to the N pieces of data, and the other data may also include the first data suitable for performing RLE. Therefore, RLE is not performed only on the first data in the N pieces of data, but is performed on the first data in the plurality of pieces of data, to avoid a loss of the first data caused by incomplete encoding of the first data.

In some implementations, each type of data in the N pieces of data is the first data suitable for performing RLE, and the encoding result may include only a corresponding first element and a corresponding second element. The first element is determined based on the first data, and the second element is a consecutive occurrence count of the first data.

Each type of first data corresponds to at least one first element, and the first element may be determined based on the first data in a plurality of manners. For example, when data with different values in the N pieces of data occupies same bits (that is, variable-length storage), a delimiter needs to exist between adjacent data. In this case, one first element may include only one piece of first data, or may include one piece of first data and one delimiter. For another example, when data with different values in the N pieces of data occupies different bits (that is, fixed-width storage, where if the data occupies fewer bits, bits occupied by the data may be increased through zero padding), there may be no delimiter between adjacent data. In this case, one first element includes one piece of first data. For another example, one first element may include one piece of first data and index information of the first data, and the index information indicates a location of the first data in the N pieces of data. It can be learned that the first element determined based on the first data includes at least the first data.

In addition, each first element corresponds to a second element. A first element is determined based on a specific type of first data, and accordingly, a second element corresponding to the first element is a consecutive occurrence count of the specific type of first data. Alternatively, the second element is a consecutive occurrence count of the first data, and the first element determined based on the first data corresponds to the second element. In an example embodiment, the second element occupies 2^{M} bits, and M is greater than or equal to 1. For example, the bit occupied by the second element may be an integer multiple of 4 bits, including but not limited to 4 bits, 8 bits, 12 bits, and the like. This is not limited herein. For example, in embodiments of this application, when all the to-be-encoded data is independent and identically distributed, the second element occupies 4 bits.

In this embodiment of this application, all first elements may form a single-value (single_values) sequence, all second elements form a repeated-count (repeated_counts) sequence, and all second elements in the repeated_counts sequence occupy same bits.

For example, if the N pieces of data are [AA, AA, AA, AA, B, B, B, AA, AA], and both AA and B are first data suitable for performing RLE, the following several cases may exist but are not limited to:

In a case of variable-length storage, AA and B occupy different bits, and a single_values sequence is [AA, B, AA]. In the single_values sequence, "," represents a delimiter, "AA" is a first element corresponding to first data AA, and "B" is a first element corresponding to first data B. Correspondingly, a repeated_counts sequence is [432], 4 is a second element corresponding to a 1^{st} "AA" in the single_values sequence, 3 is a second element corresponding to "B" in the single_values sequence, and 2 is a second element corresponding to a 2^{nd} "AA" in the single_values sequence.

In a case of fixed-width storage, AA and B occupy same bits, and a single_values sequence is [AABAA], where "AA" is a first element corresponding to first data AA, and "B" is a first element corresponding to first data B. Correspondingly, a repeated_counts sequence is [432], 4 is a second element corresponding to a 1^{st} "AA" in the single_values sequence, 3 is a second element corresponding to "B" in the single_values sequence, and 2 is a second element corresponding to a 2^{nd} "AA" in the single_values sequence.

When one first element includes one piece of first data and index information of the first data, a single_values sequence is [AA:0:7, B], "," in the single_values sequence indicates a delimiter, "AA:0:7" is a first element corresponding to first data AA, and ":0:7" is index information of the first data AA, and indicates that an offset of the first data AA relative to a 1^{st} piece of data in the N pieces of data for a 1^{st} occurrence of the first data AA in the N pieces of data is 0, an offset of the first data AA relative to the 1^{st} piece of data in the N pieces of data for a 2^{nd} occurrence of the first data AA in the N pieces of data is 7, and "B" is a first element corresponding to first data B. Correspondingly, a repeated_counts sequence is [432], 4 and 2 are second elements corresponding to the first data AA, 4 represents a consecutive occurrence count of the first data AA for the 1^{st} occurrence of the first data AA in the N pieces of data, 2 represents a consecutive occurrence count of the first data AA for the 2^{nd} occurrence of the first data AA in the N pieces of data, and 3 is a second element corresponding to the first data B, and represents a consecutive occurrence count of the first data B in the N pieces of data.

For ease of understanding in the foregoing descriptions, a decimal format is used for an example of the second element, and the second element may be in a binary format during application. For example, when the second element occupies 4 bits, a value range of the second element is 0 to 15 (in a binary format), and a consecutive occurrence count that can be represented by the second element is 1 to 16.

In addition, because the second element occupies a certain quantity of bits, there is an upper limit in the value range of the second element. If a consecutive occurrence count of one type of first data exceeds the upper limit, a new first element needs to be added to the single_values sequence, and a new second element needs to be added to the repeated_counts sequence. For example, the second element occupies 4 bits, the N pieces of data are [A...A (20 As in total) BBB], and both A and B are first data suitable for performing RLE. In this case, a single_values sequence is [AAB], "A" is a first element corresponding to first data A, "B" is a first element corresponding to first data B, and a repeated_counts sequence is [1643]. 16 and 4 are second elements corresponding to the first data A, and respectively represent that consecutive occurrence counts of the first data A are 16 and 4, and 3 is a second element corresponding to the first data B, and represents that a consecutive occurrence count of the first data B is 3.

In some other implementations, the N pieces of data include at least one type of first data suitable for performing RLE and second data not suitable for performing RLE, and the second data is data in the N pieces of data other than the first data. In this embodiment of this application, in addition to performing RLE on the first data in the N pieces of data, the second data in the N pieces of data other than the first data needs to be encoded (non-RLE), to obtain an encoding result. Correspondingly, in addition to the first element and the second element that are described above, the encoding result may further include another element. For details, refer to the following descriptions.

For example, in addition to the first element and the second element, the encoding result further includes a third element and a fourth element. The third element is determined based on the second data. An arrangement manner of the third element and the first element in the encoding result is the same as an arrangement manner of the second data and the first data in the N pieces of data. The fourth element is determined based on the first data.

For a manner of determining the third element based on the second data, refer to the foregoing described manner of determining the first element based on the first data. Details are not described herein again. In this embodiment of this application, both the third element and the first element may be located in the single_values sequence, and the arrangement manner of the third element and the first element is the same as the arrangement manner of the second data and the first data in the N pieces of data. Therefore, the arrangement manner of the second data and the first data in the N pieces of data can be naturally reflected via the third element and the first element in the single_values, and no other element needs to be additionally used to indicate the arrangement manner of the second data and the first data in the N pieces of data.

However, regardless of an arrangement manner of the third element and the first element in the encoding result, it is difficult to distinguish between the third element and the first element in the single_values sequence, and it is also difficult to distinguish between the second data that is not suitable for performing RLE and the first data that is suitable for performing RLE. Therefore, the fourth element further needs to be determined based on the first data, to distinguish the third element from the first element. For a manner of determining the fourth element based on the first data, refer to the foregoing described manner of determining the first element based on the first data. Details are not described herein again.

If data included in an element in the single_values sequence is the same as data included in the fourth element, the element in the single_values sequence is the first element, and the data included in the element is the first data that is suitable for performing RLE. Certainly, if data included in an element in the single_values sequence is different from data included in the fourth element, the element in the single_values sequence is the third element, and data indicated by the element is the second data that is not suitable for performing RLE.

In this embodiment of this application, all fourth elements may form a target set (target_set). target_set is not limited to a case in which the N pieces of data include both the first data and the second data. Even if each type of data in the N pieces of data described above is the first data suitable for performing RLE, target_set may also exist. A reason is that a data amount of target_set is small, and is usually far less than a data amount of the single_values sequence and a data amount of the repeated_counts sequence. Therefore, even with addition of target_set, an excessive or unacceptable impact does not occur in a total data amount of the encoding result.

For example, in this embodiment of this application, the third element in the single_values sequence may be in one-to-one correspondence with the second data. In this case, the third element may naturally reflect a consecutive occurrence count of the second data, and there is no need to add another element representing the consecutive occurrence count of the second data to the repeated_counts sequence. In other words, the repeated_counts sequence may include only the second element representing the consecutive occurrence count of the first data.

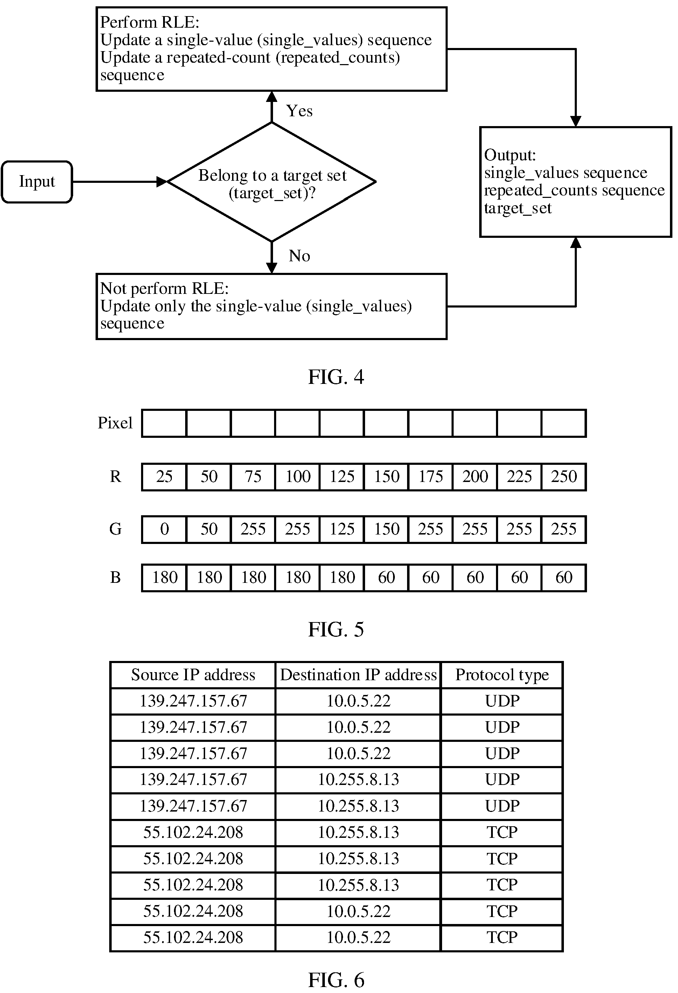

The following describes, with reference to FIG. 3 and FIG. 4, an encoding process performed by an encoder by using an example.

As shown in FIG. 3, after all to-be-encoded data is input into the encoder, the encoder samples all the to-be-encoded data to obtain N pieces of data. Then, each type of data in the N pieces of data is traversed, and whether the type of data is suitable for performing RLE is determined based on a reference threshold corresponding to the type of data. If the type of data is the first data suitable for performing RLE, the type of data is added to target_set, to obtain a fourth element in target_set. If the type of data is the second data that is not suitable for performing RLE, the type of data is not added to target_set. For example, after the traversal ends, the encoder may merge and deduplicate fourth elements in target_set, to avoid a redundant fourth element in target_set.

Then, as shown in FIG. 4, traversal is performed again starting from a 1^{st} piece of data in all the to-be-encoded data. For one piece of data, if the data belongs to target_set, or a fourth element that is determined based on the data exists in target_set, RLE is performed on the data until other data with a different value is traversed. In a process of performing RLE on the data, a single_values sequence and a repeated_counts sequence are updated based on the data, to obtain a first element in the single_values sequence and a second element in the repeated_counts sequence. If the data does not belong to target_set, or in other words, target_set does not include the fourth element determined based on the data, only the single_values sequence is updated based on the data, to obtain a third element in the single_values sequence, and the repeated_counts sequence is not updated based on the data. After the traversal ends, an encoding result obtained by the encoder includes target_set, the single_values sequence, and the repeated_counts sequence.

For example, if the N pieces of data are [AAAABBBCCDEEEEAA], A and E are first data suitable for performing RLE, and B, C, D, and E are all second data not suitable for performing RLE, in the encoding result:
target_set includes {AE}, "A" is a fourth element determined based on first data A, and "E" is a fourth element determined based on first data E.

A single_values sequence includes [ABBBCCDEA], where "A" is a first element determined based on the first data A, "B" is a third element determined based on second data B, "C" is a third element determined based on second data C, "D" is a third element determined based on second data D, and "E" is a first element determined based on the first data E.

A repeated_counts sequence includes [442], a 1^{st} 4 is a consecutive occurrence count of the first data A for a 1^{st} occurrence of the first data A in the N pieces of data, a 2^{nd} 4 is a consecutive occurrence count of the first data E in the N pieces of data, and 2 is a consecutive occurrence count of the first data A for a 2^{nd} occurrence of the first data A in the N pieces of data.

Alternatively, in addition to the first element and the second element, the encoding result may not include the third element and the fourth element, but further include a fifth element and a sixth element. The fifth element is determined based on the second data, and the sixth element indicates an arrangement manner of the second data and the first data in the N pieces of data.

For a manner of determining the fifth element based on the second data, refer to the foregoing described manner of determining the third element based on the second data. Details are not described herein again. In addition, the fifth element and the first element may be independent of each other, and are not arranged according to the arrangement manner of the second data and the first data in the N pieces of data. Therefore, it is difficult for the fifth element and the first element to naturally reflect the arrangement manner of the second data and the first data in the N pieces of data, and the sixth element needs to be additionally used to indicate the arrangement manner of the second data and the first data in the N pieces of data.

A manner in which the sixth element indicates the arrangement manner is not limited in this application. For example, when the sixth element includes a first identifier, it indicates that the second data included in the fifth element is all arranged after the first data included in the first element. For another example, when the sixth element includes a second identifier, it indicates that the second data included in the fifth element is arranged before the first data included in the first element. For another example, when the sixth element includes a third identifier, it indicates that an arrangement manner of the second data included in the fifth element and the first data included in the first element is: interpolating in a specified manner. The encoder may query a correspondence between an identifier and an arrangement manner based on an identifier included in the sixth element, to obtain an arrangement manner of second data and first data that are corresponding to the identifier in the N pieces of data.

In an encoding process performed by the encoder, after all to-be-encoded data is input into the encoder, the encoder samples all the to-be-encoded data to obtain N pieces of data. Then, each type of data in the N pieces of data is traversed, to determine, based on a reference threshold corresponding to the type of data, first data suitable for performing RLE and second data not suitable for performing RLE, and a sixth element is determined based on an arrangement manner of the first data and the second data in the N pieces of data. Then, traversal is performed again starting from a 1^{st} piece of data in the N pieces of data. For a piece of data, if the type of data belongs to the first data suitable for performing RLE, RLE is performed on the data until other data with a different value is traversed. In a process of performing RLE on the data, a single_values sequence and a repeated_counts sequence are updated based on the data, to obtain a first element in the single_values sequence and a second element in the repeated_counts sequence. If the data belongs to a third element that is not suitable for performing RLE, RLE is not performed on the data, but a fifth element is obtained based on the data. After the traversal is completed, the encoder can obtain an encoding result, where the encoding result includes the single_values sequence, the repeated_counts sequence, a sequence including all fifth elements, and the sixth element.

For example, if the N pieces of data are [AAAAAABBB], A is first data suitable for performing RLE, and B is second data not suitable for performing RLE, in the encoding result:
A single_values sequence includes [A], and "A" is a first element determined based on first data A.

A repeated_counts sequence includes [6], and 6 is a consecutive occurrence count of the first data A.

A sequence including all fifth elements is [BBB], and "B" is a fifth element determined based on second data B.

The sixth element is a first identifier, which indicates that the second data included in the fifth element is all arranged after the first data included in the first element.

The foregoing descriptions illustrate the encoding process, the first element, and the second element. Next, the reference threshold for determining whether data is suitable for performing RLE is further described. The reference threshold is determined based on N, a bit occupied by the first element, and a bit occupied by the second element. A manner of determining the reference threshold based on N, the bit occupied by the first element, and the bit occupied by the second element is not limited in embodiments of this application. N, the bit occupied by the first element, and the bit occupied by the second element are all constants that can be directly determined, and therefore, regardless of how the reference threshold is determined based on these constants, computational complexity of the reference threshold can be low.

In some implementations, the reference threshold is determined based on a ratio of a first value to a second value, the first value is a product of the bit occupied by the second element and N, and the second value is a sum of the bit occupied by the first element and the bit occupied by the second element. That the reference threshold is determined based on the ratio of the first value to the second value may indicate that the ratio of the first value to the second value is used as the reference threshold, or may indicate that a refinement result obtained after the ratio of the first value to the second value is refined is used as the reference threshold. A function of the refinement is to improve accuracy of the reference threshold. For example, during refinement, a refinement coefficient may be obtained based on experience or in another possible manner, and calculation is performed on the ratio of the first value to the second value and the refinement coefficient to obtain the refinement result.

For example, the ratio of the first value to the second value is used as the reference threshold. For each type of data in the N pieces of data, if an occurrence frequency of the type of data in the N pieces of data satisfies Formula (1), it is considered that the type of data is first data suitable for performing RLE; or if an occurrence frequency of the type of data in the N pieces of data does not satisfy Formula (1), it is considered that the type of data is second data not suitable for performing RLE: ${N}_{i} \geq \frac{{s}_{r}}{{s}_{i} + {s}_{r}} N$

In Formula (1), represents an occurrence frequency of one type of data in pieces of data, sᵢ represents a bit occupied by the first element and determined based on Vᵢ, and sᵣ represents a bit occupied by the second element.

In some other implementations, the reference threshold is determined based on the ratio of the first value to the second value. For a determining manner, refer to the foregoing descriptions. Details are not described herein again. The first value is a product of the bit occupied by the second element and N, and the second value is the bit occupied by the first element. This manner is applicable to a case in which the bit occupied by the first element are far greater than the bit occupied by the second element. In this case, a sum of the bit occupied by the first element and the bit occupied by the second element is approximately equal to the bit occupied by the first element. Therefore, the bit occupied by the second element may be directly ignored.

For example, the ratio of the first value to the second value is used as the reference threshold. For each type of data in the N pieces of data, if an occurrence frequency of the type of data in the N pieces of data satisfies Formula (2), it is considered that the type of data is first data suitable for performing RLE; or if an occurrence frequency of the type of data in the N pieces of data does not satisfy Formula (2), it is considered that the type of data is second data not suitable for performing RLE: ${N}_{i} \geq \frac{{s}_{r}}{{s}_{i}} N$

It can be seen that Formula (2) may be considered as a simplified form of Formula (1), and simplification helps reduce computational complexity, thereby reducing computational overheads in an encoding process and improving encoding efficiency. Formula (1) is a formula that has theoretical support and is obtained through a strict derivation process. For details about the derivation process, refer to the following descriptions. Details are not described herein.

For example, whether the data is suitable for performing RLE is determined according to Formula (1), , and , and in this case, a critical position at which the data is suitable for performing RLE is Nᵢ = 0.8N. All to-be-encoded data is considered as a sequence, and two sequences each with a length of 10000 are defined, namely, a sequence A whose value of N is 10000 and a sequence B whose value of N is 10000. In the sequence A, when values of 8000 random locations are 1, and values of the remaining 2000 locations are 0, data whose value is 1 in the sequence A is precisely suitable for performing RLE, and data whose value is 0 is not suitable for performing RLE. In addition, one or two pieces of data are randomly selected from the 8000 pieces of data, each with a value of 1, that are included in the sequence A, and a value of the selected data is replaced from 1 to 0, to obtain the sequence B. In this case, data whose value is 1 in the sequence B is precisely not suitable for performing RLE, and data whose value is 0 is also not suitable for performing RLE. Therefore, if RLE is performed on data suitable for performing RLE, a data amount of an encoding result corresponding to the sequence A is less than a data amount of an encoding result corresponding to the sequence B, and is also less than a data amount of the sequence A.

The following describes, by using an example, a process of applying the encoding method provided in embodiments of this application to various service scenarios. As described above, a data amount of target_set is far less than a data amount of the single_values sequence and a data amount of the repeated_counts sequence. Therefore, in the following examples, the data amount of target_set is not considered during calculation of a data amount of an encoding result.

In Example 1, in an image compression service scenario, RLE may be performed on an image that complies with an international telecommunication union (international telecommunication union, ITU) or an international organization for standardization (international organization for standardization, ISO) standard, to implement image compression. The images that comply with the ITU or ISO standard include but are not limited to images in the following formats: joint photographic experts group (joint photographic experts group, JPEG), tag image file format (tag image file format, TIFF), bitmap (bitmap, BMP), and PC paintbrush exchange (PC paintbrush exchange, PCX). PC paintbrush is a type of software.

As shown in FIG. 5, an image includes 10 pixels, and each pixel corresponds to three color channels: red (red, R), green (green, G), and blue (blue, B). Therefore, a data sequence corresponding to R, a data sequence corresponding to G, and a data sequence corresponding to B can be obtained through decomposition. Each data sequence includes 10 pieces of data. Each data sequence is encoded by using the encoding method provided in embodiments of this application. Because a value of a pixel on a color channel is any value from 0 to 255, fixed-width storage is used for each piece of data. To be specific, each piece of data occupies 8 bits, and each data sequence occupies 80 bits, that is, . In addition, it is set that .

Each type of data in the data sequence corresponding to R is not suitable for performing RLE. Therefore, in an encoding result, target_set is an empty set {}, a single_values sequence is [25, 50, 75, 100, 125, 150, 175, 200, 225, 250], and a repeated_counts sequence is also empty []. Herein, "," is added to the single_values sequence only for ease of distinguishing different data. "," herein is not a delimiter that needs to occupy a bit. Therefore, after the data sequence corresponding to R is compressed, the obtained encoding result occupies 80 bits, which is the same as the 80 bits occupied before compression. Deterioration does not occur.

In the data sequence corresponding to G, data with a value of 255 is suitable for performing RLE, and data with another value is not suitable for performing RLE. Therefore, in an encoding result, target_set is {255}, a single_values sequence is [0, 50, 255, 125, 150, 255], and a repeated_counts sequence is [24]. "," in the single_values sequence is not a delimiter that needs to occupy a bit. Therefore, after the data sequence corresponding to G is compressed, the obtained encoding result occupies 64(6*8+2*8) bits, which is less than 80 bits occupied before compression.

Data of each value in the data sequence corresponding to B is suitable for performing RLE. Therefore, in an encoding result, target_set is {180, 60}, a single_values sequence is [180, 60], a repeated_counts sequence is [55], and "," in the single_values sequence is not a delimiter that needs to occupy a bit. Therefore, after the data sequence corresponding to B is compressed, the obtained encoding result occupies 32(2*8+2*8) bits, which is less than 80 bits occupied before compression.

It can be learned that, in a case of sᵢ = 8 using fixed-width storage and sᵣ =8, for a data sequence corresponding to each color channel, bits occupied after compression do not exceed bits occupied before compression.

In Example 2, in a service scenario of a database, RLE may be performed on data stored in the database, to implement data compression. The database includes but is not limited to the following types: MongoDB, InfluxDB, and TimescaleDB (all are database names).

As shown in FIG. 6, a database stores data in a form of a table, and performs division by column, to obtain a data sequence corresponding to a source internet protocol (internet protocol, IP) address, a data sequence corresponding to a destination IP address, and a data sequence corresponding to a protocol type, where the protocol type includes a user datagram protocol (user datagram protocol, UDP) and a transmission control protocol (transmission control protocol, TCP). Certainly, the source IP address, the destination IP address, and the protocol type are merely examples, and a data sequence corresponding to a feature such as a port number and an application type may be further included. Each data sequence includes 10 pieces of data, and each piece of data is stored with a variable bit width. For example, in a data sequence corresponding to a source IP, data "139.247.157.67" occupies 112(14*8) bits, "55.102.24.208" occupies 104(13*8) bits, and there is a delimiter occupying 8 bits between different data. In addition, it is set that .

The data sequence corresponding to the source IP occupies 1152(112*5+104*5+9*8) bits, and both "139.247.157.67" and "55.102.24.208" are suitable for performing RLE. In an encoding result, target_set is {139.247.157.67, 55.102.24.208}, a single_values sequence is [139.247.157.67, 55.102.24.208], a repeated_counts sequence is [55], and "," in the single_values sequence is a delimiter that needs to occupy a bit. Therefore, the encoding result obtained after compression occupies 232(112*1+104*1+1*8+2*4) bits, which is less than 1152 bits occupied before compression.

A data sequence corresponding to a destination IP occupies 824(9*8*8+11*8*2+9*8) bits, and both "10.0.5.22" and "10.255.8.13" are suitable for performing RLE. In an encoding result, target_set is {10.0.5.22, 10.255.8.13}, a single_values sequence is [10.0.5.22, 10.255.8.13, 10.0.5.22], a repeated_counts sequence is [352], and "," in the single_values sequence is a delimiter that needs to occupy a bit. Therefore, the encoding result obtained after compression occupies 260(9*8*1+11*8*1+9*8*1+2*8+3*4) bits, which is less than 824 bits occupied before compression.

A data sequence corresponding to a protocol type occupies 312(3*8*5+3*8*5+9*8) bits, and both "UDP" and "TCP" are suitable for performing RLE. In an encoding result, target_set is {UDP, TCP}, a single_values sequence is [UDP, TCP], a repeated_counts sequence is [55], and "," in the single_values sequence is a delimiter that needs to occupy a bit. Therefore, the encoding result obtained after compression occupies 64(3*8*1+3*8*1+1*8+2*4) bits, which is less than 312 bits occupied before compression.

It can be learned that, in a case of sᵢ using variable-length storage and sᵣ = 4, for a data sequence corresponding to each column, bits occupied after compression are all less than bits occupied before compression.

In Example 3, in a communication service scenario, RLE may be performed on signals in a plurality of formats such as an analog television signal, a fax signal, and a digital signal, to facilitate transmission in a communication process.

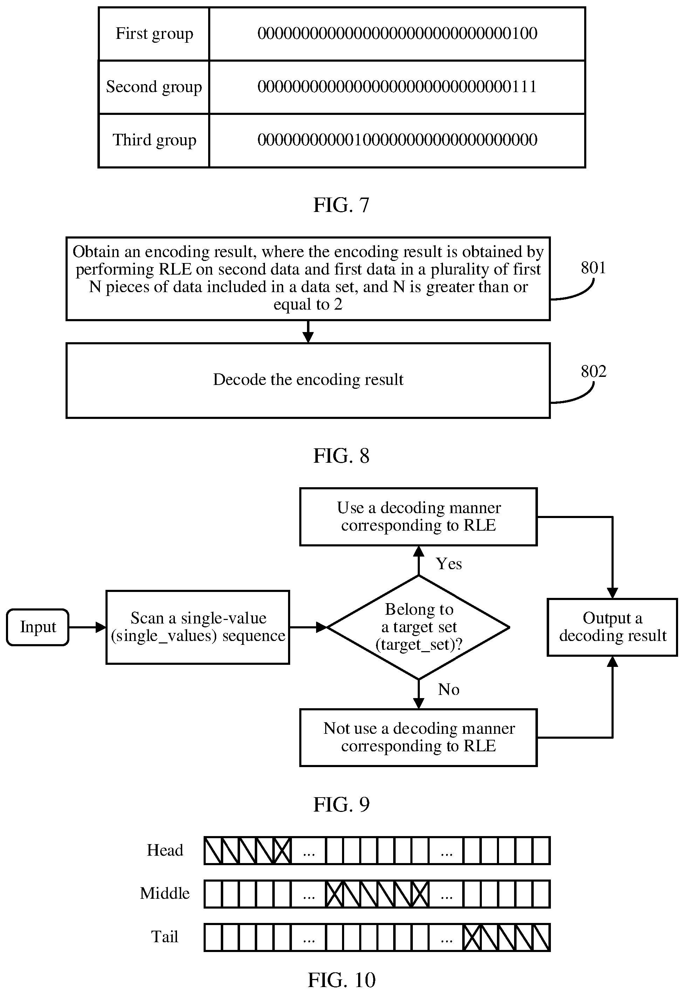

As shown in FIG. 7, a binary signal that needs to be transmitted is 00000000 00000000 00000000 00000100 00000000 00000000 00000000 00000111 00000000 00010000 00000000 00000000, and each piece of data is stored using fixed-width storage, and each piece of data occupies 1 bit, that is sᵢ = 1. The binary signal is divided into three groups, and a data sequence corresponding to each group occupies 32 bits. In addition, it is set that . In the data sequence corresponding to each group, the data 0 is suitable for performing RLE, and the data 1 is not suitable for performing RLE.

For a data sequence corresponding to a first group, in an encoding result, target_set is {0}, a single_values sequence is [0, 1, 0], a repeated_counts sequence is [29, 2], and neither "," in the single_values sequence nor "," in the repeated_counts sequence is a delimiter that needs to occupy a bit. Therefore, the encoding result obtained after compression occupies 19(3*1+2*8) bits, which is less than 32 bits occupied before compression.

For a data sequence corresponding to a second group, in an encoding result, target_set is {0}, a single_values sequence is [0, 1, 1, 1], a repeated_counts sequence is [29], and "," in the single_values sequence is not a delimiter that needs to occupy a bit. Therefore, 12(4*1+1*8) bits are occupied after compression, which is less than 32 bits occupied before compression.

For a data sequence corresponding to a third group, in an encoding result, target_set is {0}, a single_values sequence is [0, 1, 0], a repeated_counts sequence is [11, 20], and neither "," in the single_values sequence nor "," in the repeated_counts sequence is a delimiter that needs to occupy a bit. Therefore, 19(3*1+2*8) bits are occupied after compression, which is less than 32 bits occupied before compression.

It can be learned that, in a case of sᵢ = 1 using fixed-width storage and sᵣ = 8, for a data sequence corresponding to each group, bits occupied after compression are all less than bits occupied before compression.

In conclusion, in embodiments of this application, the first data suitable for performing RLE is determined from the N pieces of data based on the reference threshold. Therefore, RLE is performed on the first data that is suitable for performing RLE, and RLE does not need to be performed on data that is not suitable for performing RLE, thereby implementing proper and selective RLE and avoiding unnecessary encoding overheads.

In addition, because the reference threshold is determined based on N, the bit occupied by the first element, and the bit occupied by the second element, the reference threshold has theoretical support and low computational complexity, and the first data suitable for performing RLE can be quickly and accurately determined based on the reference threshold. Therefore, not only is deterioration after RLE avoided, but computational overheads are also reduced, further improving encoding efficiency.

In addition, encoding is performed according to the encoding method shown in FIG. 2, to obtain an encoding result. In this case, an embodiment of this application further provides a decoding method shown in FIG. 8. The decoding method is used to decode the encoding result. The decoding method may be applied to the software 101 shown in FIG. 1, and the software 101 is deployed in the product 102. In embodiments of this application, the encoding method and the decoding method may be applied to same software, or may be applied to different software. When the encoding method and the decoding method are applied to different software, the different software may be deployed in a same product, or may be deployed in different products. As shown in FIG. 8, the decoding method includes the following step 801 and step 802.

Step 801: Obtain an encoding result, where the encoding result is obtained by performing RLE on first data in N pieces of data included in a data set, and N is greater than or equal to 2.

An occurrence frequency of the first data in the N pieces of data is greater than or equal to a reference threshold, the reference threshold is determined based on N, a bit occupied by a first element, and a bit occupied by a second element, the first element is determined based on the first data, and the second element is a consecutive occurrence count of the first data.

For example, the second element occupies 2^{M} bits, and M is greater than or equal to 1.

In an example embodiment, the reference threshold is determined based on a ratio of a first value to a second value, the first value is a product of the bit occupied by the second element and N, and the second value is a sum of the bit occupied by the first element and the bit occupied by the second element.

For content related to step 801, refer to the descriptions in step 201 and step 202. Details are not described herein again.

Step 802: Decode the encoding result.

In some implementations, each type of data in the N pieces of data is first data suitable for performing RLE, and the encoding result includes only a corresponding first element and a corresponding second element. Because a first element in a single_values sequence includes the first data, and a second element in a repeated_counts sequence is a consecutive occurrence count of the first data, the single_values sequence may be traversed in a decoding process. For the first data included in each first element, the first data is consecutively output based on the consecutive occurrence count represented by the second element corresponding to the first element in the repeated_counts sequence. For example, if the consecutive occurrence count is 5, five pieces of first data are consecutively output, to obtain a decoding result.

In some other implementations, the encoding result is further obtained by encoding second data in the N pieces of data other than the first data. The encoding result includes the first element, the second element, a third element, and a fourth element. The third element is determined based on the second data. An arrangement manner of the third element and the first element in the encoding result is the same as an arrangement manner of the second data and the first data in the N pieces of data. The fourth element is determined based on the first data. The third element and the first element are located in the single_values sequence, and the fourth element is located in target_set. Correspondingly, the decoding the encoding result includes: decoding the first element and the third element based on the second element and the fourth element.

The following describes, with reference to FIG. 9, a decoding process performed by a decoder by using an example.

As shown in FIG. 9, after receiving an encoding result, the decoder scans a single_values sequence in the encoding result, and performs traversal starting from a 1^{st} element in the single_values sequence. If data included in an element is the same as data included in a fourth element in target_set, it is determined that the element is a first element, and the data included in the first element is first data that is suitable for performing RLE. Therefore, the first data is consecutively output based on a consecutive occurrence count indicated by a 1^{st} second element existing in a repeated_counts sequence, then, the 1^{st} second element existing in the repeated_counts sequence is deleted. If data included in an element is different from data included in a fourth element in target_set, it is determined that the element is a third element, and the data included in the third element is second data that is not suitable for performing RLE. Therefore, the second data included in the third element is directly output. After the traversal is completed, a decoding result is obtained and output.

For example, in an encoding result, target_set includes {AE}, a single_values sequence includes [ABBBCCDEA], and a repeated_counts sequence includes [442]. Correspondingly, in a decoding process:

The single_values sequence is scanned. Because A is located in target_set, A is repeatedly output four times according to a 1^{st} 4 in the repeated_counts sequence to obtain a sequence [AAAA], and the 1^{st} 4 in the repeated_counts sequence is deleted to obtain an updated repeated_counts sequence [42].

The single_values sequence continues to be scanned. Because none of B, C, and D is in target_set, a sequence [AAAABBBCCD] is directly output and obtained.

The single_values sequence continues to be scanned. Because E is located in target_set, E is repeatedly output four times according to a 1^{st} 4 in the updated repeated_counts sequence [42] to obtain a sequence [AAAABBBCCDEEEE], and the 1^{st} 4 in the updated repeated_counts sequence [42] is deleted to obtain a second-updated repeated_counts sequence [2].

The single_values sequence continues to be scanned. Because A is located in target_set, A is repeatedly output twice according to a 1^{st} 2 in the second-updated repeated_counts sequence [2], to obtain a sequence [AAAABBBCCDEEEEAA], the 1^{st} 2 in the second-updated repeated_counts sequence [2] is deleted, and the sequence [AAAABBBCCDEEEEAA] is output as a decoding result.

In some other implementations, the encoding result is further obtained by encoding second data in the N pieces of data other than the first data. The encoding result includes the first element, the second element, a fifth element, and a sixth element. The fifth element is determined based on the second data, and the sixth element indicates an arrangement manner of the second data and the first data in the N pieces of data. The first element is located in the single_values sequence, and the second element is located in the repeated_counts sequence. Correspondingly, the decoding the encoding result includes: decoding the first element and the fifth element based on the second element and the sixth element.

After receiving an encoding result, the decoder scans a single_values sequence in the encoding result, performs traversal starting from a 1^{st} element in the single_values sequence, consecutively outputs, based on a consecutive occurrence count indicated by a 1^{st} second element existing in a repeated_counts sequence, first data included in the first element, and then deletes the 1^{st} second element in existing the repeated_counts sequence, to obtain a first decoding result after the traversal is completed. In addition, the fifth element is scanned, and the second data included in the fifth element is directly output, to obtain a second decoding result. Then, the first decoding result and the second decoding result are arranged according to the arrangement manner that is of the second data and the first data in the N pieces of data and that is indicated by the sixth element, to obtain a decoding result.

For example, in an encoding result, a single_values sequence includes [A], a repeated_counts sequence includes [6], a sequence including all fifth elements is [BBB], and a sixth element indicates that second data is all arranged after first data. Correspondingly, in a decoding process:

The single_values sequence is scanned, A is consecutively output six times according to a 1^{st} 6 in the repeated_counts sequence to obtain a first decoding result [AAAAAA], and the 1^{st} 6 in the repeated_counts sequence is deleted.

The sequence including all the fifth elements is scanned to obtain a second decoding result [BBB].

Because the sixth element indicates that the second data is all arranged after the first data, the decoder arranges [BBB] after the [AAAAAA], to obtain and output a decoding result [AAAAAABBB].

In conclusion, according to the decoding method provided in this embodiment of this application, an encoding result can be decoded, to implement lossless data restoration. The encoding result is obtained by performing encoding according to the encoding method shown in FIG. 2. For a technical effect of the encoding result, refer to the descriptions in the encoding method. Details are not described herein again.

The foregoing separately describes the encoding method and the decoding method provided in embodiments of this application. The following describes a derivation process of Formula (1).

The N pieces of data include data with i different values in total, an occurrence frequency of an i^{th} type of data Vᵢ in the N pieces of data is Nᵢ, and an occurrence probability of the i^{th} type of data Vᵢ in the N pieces of data is pᵢ = Nᵢ/N, or Nᵢ = Npᵢ. If RLE is performed on the data Vᵢ, a single_values sequence is generated. The occurrence frequency of Vᵢ can be reduced through RLE, a reduction is denoted as an expectation ${E}_{reduce}^{i}$, and ${E}_{reduce}^{i}$ is expressed as Formula (3): $\begin{matrix}{E}_{reduce}^{i} = occurence frequency of {V}_{i} in the N pieces of data - occurence frequency of {V}_{i} in the \\ single_values sequence\end{matrix}$

Certainly, in addition to the single_values sequence, a repeated_counts sequence is also generated, and the single_values sequence and the repeated_counts sequence include a same quantity of elements. Therefore, a bit occupied by an element corresponding to the data Vᵢ in the single_values sequence are denoted as sᵢ, and a bit occupied by an element corresponding to the data Vᵢ in the repeated_counts sequence are denoted as sᵣ, so that a condition that no deterioration occurs after RLE is performed on the data Vᵢ is denoted as Formula (4): ${Np}_{i} ⋅ {s}_{i} \geq \left({Np}_{i}-{E}_{reduce}^{i}\right) ⋅ {s}_{r} + \left({Np}_{i}-{E}_{reduce}^{i}\right) ⋅ {s}_{i}$

In Formula (4), Npᵢ ▪ sᵢ is a quantity of bit occupied by the data Vᵢ in the N pieces of data, ( ${Np}_{i} - {E}_{reduce}^{i}$) is the occurrence frequency of Vᵢ in the single_values sequence that is described in Formula (3), $\left({Np}_{i}-{E}_{reduce}^{i}\right) ⋅ {s}_{r}$ is a bit occupied by the data Vᵢ in the repeated_counts sequence, and $\left({Np}_{i}-{E}_{reduce}^{i}\right) ⋅ {s}_{i}$ is a bit occupied by the data Vᵢ in the single_values sequence.

If Formula (4) is directly used, ${E}_{reduce}^{i}$ needs to be solved. In a solving process, complete RLE is performed on the N pieces of data to obtain a reference encoding result, ${E}_{reduce}^{i}$ of each type of data Vᵢ is obtained through solving based on the reference encoding result, and then calculation is performed on Formula (4) for each type of data Vᵢ by using ${E}_{reduce}^{i}$, to verify whether the formula is satisfied. If the formula is satisfied, it is determined that the data Vᵢ is suitable for performing RLE; if the formula is not satisfied, it is determined that the data Vᵢ is not suitable for performing RLE. In this way, a determined result is obtained. Then, RLE is performed again based on the determined result. If a determined result of a type of data Vᵢ indicates that the data is suitable for performing RLE, RLE is performed on the data Vᵢ when RLE is performed again; or if a determined result of a type of data Vᵢ indicates that the data is not suitable for performing RLE, RLE is not performed on the data Vᵢ when RLE is performed again.

It can be seen that, two rounds of RLE need to be performed in the foregoing solving process, causing high encoding overheads, low encoding efficiency, and poor practicability. In addition, the 1^{st} complete RLE alone carries computational complexity of O(N), and the computational complexity is high. Therefore, in embodiments of this application, Formula (4) is simplified, to obtain Formula (1) whose computational complexity is O(1), so as to obtain an encoding method with low computational complexity. In this way, the encoding method is applicable to fields such as an information and communications technology (information and communications technology, ICT), and massive data needs to be encoded by using low overheads in these fields.

According to a pigeonhole principle, a lossless compression algorithm that has no deterioration on any data distribution may not exist. Therefore, data distribution of to-be-encoded data needs to be assumed based on a service scenario. According to analysis, in service scenarios such as image compression, database, and communication, the to-be-encoded data better conforms to independent and identical distribution. Therefore, it may be assumed that the data distribution is independent and identical distribution. In addition, the occurrence probability pᵢ of the data Vᵢ in the N pieces of data may be an observation value. To avoid an excessively large deviation between the observation value and a real value caused by an accidental error, it may be further assumed that a quantity of to-be-encoded data is sufficient.

Based on this, a reference sequence is defined, and the reference sequence exactly includes n pieces of data Vᵢ. In other words, a consecutive occurrence count of the data Vᵢ is exactly n. When the N pieces of data are scanned from the beginning to the end, an expected occurrence count of the reference sequence is denoted as E. As shown in FIG. 10, in the N pieces of data, locations at which the reference sequence occurs may be classified into three types: a head, a middle, and a tail. It is easy to understand that, in FIG. 10, an example in which a value of n is 4 is used. In addition, a "single slash" represents data Vᵢ included in the reference sequence, and "cross lines" represents other data whose value is different from a value of the data Vᵢ. Under the assumption of independent and identical distribution described above, pᵢ is equal to the occurrence probability of the data Vᵢ in any location in the N pieces of data. In this case, the expected occurrence count E of the reference sequence at the head or the tail is represented by Formula (5), and the expected occurrence count E of the reference sequence in the middle is represented by Formula (6): $E = \left(1-{p}_{i}\right) {{p}_{i}}^{n}$ $E = \left(1-{p}_{i}\right) {{p}_{i}}^{n} \left(1-{p}_{i}\right) \left(N-n-1\right)$

If n ≤ N - 2, the reference sequence may occur in any one or more of the three locations: head, middle, or tail. If n = N - 1, the reference sequence may occur at the head or the tail, and the expected occurrence count E is (1 - pᵢ)pᵢ^{N-1}. If n = N, the N pieces of data are all of the same type of data Vᵢ, and the expected occurrence count E is pᵢ^{N}.

After RLE is performed on a reference sequence that includes n pieces of data Vᵢ, a quantity Q of elements corresponding to the data Vᵢ in a single_values sequence and a quantity Q of elements corresponding to the data Vᵢ in a repeated_counts sequence are both represented as Formula (7), where a symbol in Formula (7) is a ceiling symbol: $Q = \left⌈\frac{n}{{2}^{{s}_{r}}}\right⌉$

In addition, in the Q elements included in the repeated_counts sequence, a value of one element is (n mod 2^{sᵣ}) - 1, mod is a modulo operator, (n mod 2^{sᵣ}) represents a remainder obtained by dividing 2^{sᵣ} by n, and a value of a remaining element is 2^{sᵣ} - 1.

Therefore, each time the reference sequence occurs, a contribution W generated for ${E}_{reduce}^{i}$ is represented by Formula (8): $W = n - \left⌈\frac{n}{{2}^{{s}_{r}}}\right⌉$

Based on the foregoing derivation, Formula (9) can be obtained: $\begin{matrix}{E}_{reduce}^{i} = {\sum }_{n = 2}^{N - 2} \left(2\left(1-{p}_{i}\right){{p}_{i}}^{n}+\left(1-{p}_{i}\right){{p}_{i}}^{n}\left(1-{p}_{i}\right)\left(N-1-n\right)\right) \left(n-\left⌈\frac{n}{{2}^{{s}_{r}}}\right⌉\right) \\ + 2 \left(1-{p}_{i}\right) {{p}_{i}}^{N - 1} \left(N-1-\left⌈\frac{N - 1}{{2}^{{s}_{r}}}\right⌉\right) + {{p}_{i}}^{N} \left(N-\left⌈\frac{N}{{2}^{{s}_{r}}}\right⌉\right) \\ = {\sum }_{n = 2}^{N - 1} \left(2\left(1-{p}_{i}\right){{p}_{i}}^{n}+\left(1-{p}_{i}\right){{p}_{i}}^{n}\left(1-{p}_{i}\right)\left(N-1-n\right)\right) \left(n-\left⌈\frac{n}{{2}^{{s}_{r}}}\right⌉\right) \\ + {{p}_{i}}^{N} \left(N-\left⌈\frac{N}{{2}^{{s}_{r}}}\right⌉\right)\end{matrix}$

An error term ε₁ is defined according to Formula (10): ${ϵ}_{1} = {{p}_{i}}^{N} \left(N-\left⌈\frac{N}{{2}^{{s}_{r}}}\right⌉\right)$

Formula (9) may be simplified into Formula (11): $\begin{matrix}{E}_{reduce}^{i} = {\sum }_{n = 2}^{N - 1} \left(2\left(1-{p}_{i}\right){{p}_{i}}^{n}+\left(1-{p}_{i}\right){{p}_{i}}^{n}\left(1-{p}_{i}\right)\left(N-1-n\right)\right) \left(n-\left⌈\frac{n}{{2}^{{s}_{r}}}\right⌉\right) + {ϵ}_{1} \\ = {\sum }_{n = 1}^{N - 1} \left(\left(1-{p}_{i}\right)\left({p}_{i}-1\right)n+\left(1-{p}_{i}\right)\left(\left(1-{p}_{i}\right)\left(N-1\right)+2\right)\right) {{p}_{i}}^{n} \left(n-\left⌈\frac{n}{{2}^{{s}_{r}}}\right⌉\right) \\ + {ϵ}_{1}\end{matrix}$

Next, Formula (11) needs to be further simplified.

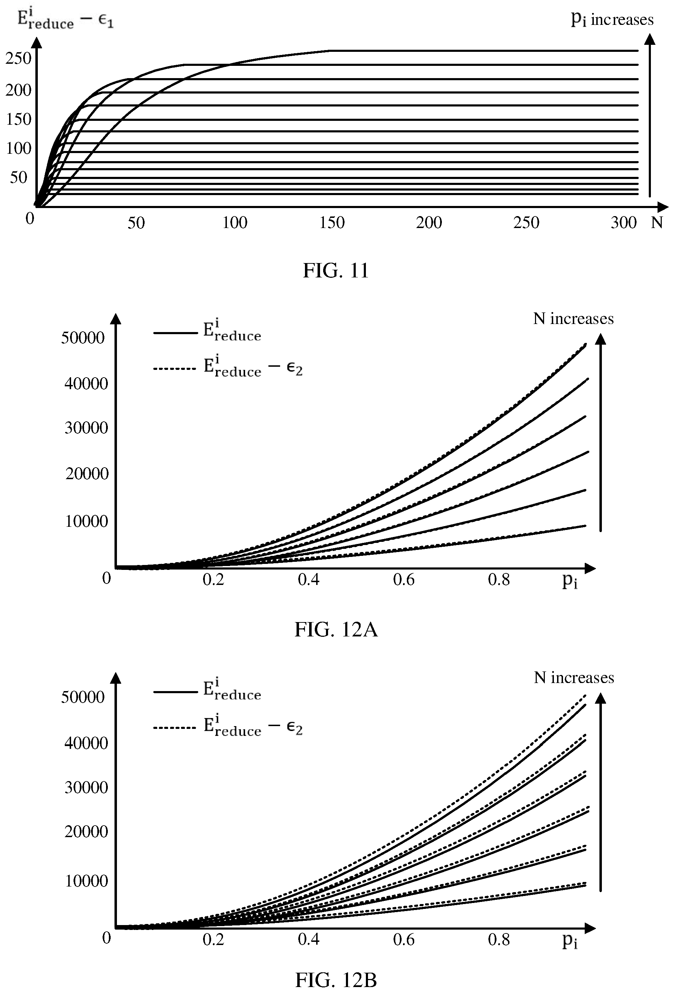

It can be learned with reference to FIG. 11 that, when N is relatively small, ${E}_{reduce}^{i} - {ϵ}_{1}$ ε₁ has shown a significant convergence trend, and a convergence value exists. Therefore, a function used to approximate the convergence value may be found. Two constants are defined according to Formula (12) and Formula (13): ${k}_{α} = \left(1-{p}_{i}\right) \left({p}_{i}-1\right)$ ${k}_{β} = \left(1-{p}_{i}\right) \left(\left(1-{p}_{i}\right)\left(N-1\right)+2\right)$

In this case, Formula (11) may be represented as Formula (14): ${E}_{reduce}^{i} = {\sum }_{n = 1}^{N - 1} \left({k}_{α}n+{k}_{β}\right) {{p}_{i}}^{n} \left(n-\left⌈\frac{n}{{2}^{{s}_{r}}}\right⌉\right) + {ϵ}_{1}$

When n ≥ 2^{sᵣ} + 1, Formula (15) exists: $- 1 - \frac{n}{{2}^{{s}_{r}}} \leq - \left⌈\frac{n}{{2}^{{s}_{r}}}\right⌉ < - 1$

An error term ε₂ is defined according to Formula (16): ${ϵ}_{2} ∈ \left[{\sum }_{n = {2}^{{s}_{r}} + 1}^{N - 1} \left({k}_{α}n+{k}_{β}\right) {{p}_{i}}^{n}\left(-\frac{n}{{2}^{{s}_{r}}}\right),0\right)$

In this case, Formula (14) may be represented as Formula (17): ${E}_{reduce}^{i} = {\sum }_{n = 1}^{N - 1} \left({k}_{α}n+{k}_{β}\right) {{p}_{i}}^{n} \left(n-1\right) + {ϵ}_{1} + {ϵ}_{2}$

When n < 2^{sᵣ} + 1, a value of a term with a ceiling symbol in Formula (15) is always 1, and there is no error. Therefore, no special processing is required.

To substitute the summation symbol in Formula (17), the following three lemmas are proved.

In Lemma 1, when a∈ (0,1), Formula (18) is obtained according to a formula of summation for geometric sequence, and then Lemma 1 may be expressed as Formula (20) in combination with Formula (19), where s. t. in Formula (19) represents subject to (subject to): ${\sum }_{n = 0}^{N} {a}^{n} = \frac{{a}^{0} \left(1-{a}^{N}\right)}{1 - a}$ ${lim}_{N \to ∞} \frac{{a}^{0} \left(1-{a}^{N}\right)}{1 - a} = \frac{1}{1 - a} s . t . a ∈ \left(0, 1\right)$ ${\sum }_{n = 0}^{∞} {a}^{n} = \frac{1}{1 - a}$

In Lemma 2, when a∈ (0,1), Formula (21) can be obtained by differentiating both sides of the equals sign in Lemma 1 with respect to a at the same time, and therefore, Lemma 2 may be expressed as Formula (22) from Formula (21): ${\sum }_{n = 0}^{∞} {a}^{n - 1} n = \frac{1}{{\left(1-a\right)}^{2}} \to {\sum }_{n = 1}^{∞} {a}^{n} n = \frac{a}{{\left(1-a\right)}^{2}}$ ${\sum }_{n = 0}^{∞} {a}^{n} n = \frac{a}{{\left(1-a\right)}^{2}}$

In Lemma 3, when a∈ (0,1), Formula (23) can be obtained by differentiating both sides of the equals sign in Lemma 2 with respect to a at the same time, and Lemma 3 may be expressed as Formula (24) by multiplying the two sides of the equals sign in Formula (23) by a at the same time: ${\sum }_{n = 0}^{∞} {a}^{n - 1} {n}^{2} = \frac{{\left(1-a\right)}^{2} + 2 a \left(1-a\right)}{{\left(1-a\right)}^{4}} = \frac{a + 1}{{\left(1-a\right)}^{3}}$ ${\sum }_{n = 0}^{∞} {a}^{n} {n}^{2} = \frac{{a}^{2} + a}{{\left(1-a\right)}^{3}}$

Because N is large enough, according to Lemma 1, Lemma 2, and Lemma 3 (pᵢ is a in these lemmas), the summation symbol in Formula (17) may be substituted with a convergence value of an infinite series. Therefore, an error term ε₃ may be introduced (in a substitution process), and Formula (17) may be simplified into Formula (25): $\begin{matrix}{E}_{reduce}^{i} = {\sum }_{n = 1}^{N - 1} \left({k}_{α}n+{k}_{β}\right) {{p}_{i}}^{n} \left(n-1\right) + {ϵ}_{1} + {ϵ}_{2} \\ = {k}_{α} {\sum }_{n = 1}^{N - 1} {{p}_{i}}^{n} {n}^{2} + \left({k}_{β}-{k}_{α}\right) {\sum }_{n = 1}^{N - 1} {{p}_{i}}^{n} n - {k}_{β} {\sum }_{n = 1}^{N - 1} {{p}_{i}}^{n} + {ϵ}_{1} + {ϵ}_{2} \\ = {k}_{α} \left(\frac{{{p}_{i}}^{2} + {p}_{i}}{{\left(1-{p}_{i}\right)}^{3}}-0\right) + \left({k}_{β}-{k}_{α}\right) \left(\frac{{p}_{i}}{{\left(1-{p}_{i}\right)}^{2}}-0\right) - {k}_{β} \left(\frac{1}{1 - {p}_{i}}-1\right) + {ϵ}_{1} \\ + {ϵ}_{2} + {ϵ}_{3} = E \left({p}_{i}, N\right) + {ϵ}_{1} + {ϵ}_{2} + {ϵ}_{3}\end{matrix}$

The error terms ε₁, ε₂, and ε₃ are ignored, and Formula (12) and Formula (13) are substituted into Formula (25), to obtain Formula (26): ${E}_{reduce}^{i} = E \left({p}_{i}, N\right) = \left(N-1\right) {{p}_{i}}^{2}$

In embodiments of this application, the error terms ε₁, ε₂, and ε₃ can be ignored because of the following reasons.

First, for the error term ε₁, when N > 0 and pᵢ < 1 (because the N pieces of data are of the same type when pᵢ = 1, RLE may be directly performed without analysis), Formula (27) monotonically increases: $f \left(x\right) = \frac{lnx}{x}$

Therefore, Formula (28) exists: $\frac{ln \left({Np}_{i}\right)}{{Np}_{i}} < \frac{ln \left(N\right)}{N} \to Nln \left({Np}_{i}\right) < \left({Np}_{i}\right) ln \left(N\right) \to {\left({Np}_{i}\right)}^{N} < {N}^{{Np}_{i}} \to \frac{{\left({Np}_{i}\right)}^{N}}{{N}^{{Np}_{i}}} < 1$

In addition, when pᵢ < 1, because Npᵢ is always an integer, Formula (29) exists when N - Npᵢ ≥ 1,: ${ϵ}_{1} = {{p}_{i}}^{N} \left(N-\left⌈\frac{N}{{2}^{{s}_{r}}}\right⌉\right) < {{p}_{i}}^{N} N = \frac{{\left({Np}_{i}\right)}^{N}}{{N}^{{Np}_{i}}} ⋅ \frac{N}{{N}^{N - {Np}_{i}}} \leq {N}^{1 - \left(N-{Np}_{i}\right)} \leq 1$

Then, it may be obtained that ε₁ ∈ (0, 1] ≪ N, and therefore, ε₁ may be ignored.

Second, for the error term ε₂, Formula (30) is obtained according to Formula (16), Lemma 1, Lemma 2, and Lemma 3: $\begin{matrix}\left|{\sum }_{n = {2}^{{s}_{r}} + 1}^{N - 1} \left({k}_{α}n+{k}_{β}\right) {{p}_{i}}^{n} \left(-\frac{n}{{2}^{{s}_{r}}}\right)\right| = \frac{1}{{2}^{{s}_{r}}} ⋅ \left[{\sum }_{n = 0}^{N - 1} \left({k}_{α}n+{k}_{β}\right) {{p}_{i}}^{n} n - {\sum }_{n = 0}^{{2}^{{s}_{r}}} \left({k}_{α}n+{k}_{β}\right) {{p}_{i}}^{n} n\right] \\ = \frac{1}{{2}^{{s}_{r}}} ⋅ \left[{k}_{α}⋅\frac{{{p}_{i}}^{2} + {p}_{i}}{{\left(1-{p}_{i}\right)}^{3}}+{k}_{β}⋅\frac{{p}_{i}}{{\left(1-{p}_{i}\right)}^{2}}-{\sum }_{n = 0}^{{2}^{{s}_{r}}} \left({k}_{α}n+{k}_{β}\right) {{p}_{i}}^{n} n\right]\end{matrix}$

Therefore, Formula (30) is a constant, and 2^{sᵣ} ▪ |ε₂| is also a constant. An impact brought by ε₂ is mainly related to sᵣ. A larger value of sᵣ indicates a smaller impact brought by ε₂. With reference to FIG. 12A, it can be learned that when sᵣ = 8 (that is, one byte), an impact brought by ε₂ almost completely disappears, because a degree of coincidence between a solid line and a dashed line in FIG. 12A is very high. With reference to FIG. 12B, it can be learned that when sᵣ = 4 (that is, half of a byte), an impact brought by ε₂ is also very small (which may be observed when pᵢ > 0.8), because a degree of coincidence between a solid line and a dashed line in FIG. 12B is also relatively high. Because the impact brought by sᵣ is very small, ε₂ can be directly ignored.

Third, for the error term ε₃ with relatively high quantization difficulty, because ${E}_{reduce}^{i}$ has shown a significant convergence trend when N is relatively small, and N is usually relatively large, ε₃ brought by substituting the summation symbol for the convergence value of the infinite series may also be ignored.

In embodiments of this application, to further prove that the foregoing three error terms are all negligible, an experiment is performed. In the experiment, when values of N are respectively 1024, 2048, and 4096 (that is, N has three values in total), values of pᵢ are respectively 0%, 5%, ..., and 95% (that is, pᵢ has 20 values in total), and data is randomly selected from the N pieces of data to replace data Vᵢ occupying sᵢ bits (that is, a value of data Vᵢ is different from a value of data included in the N pieces of data). Next, sᵣ is set, and RLE is used for encoding. For each group of sᵢ and sᵣ, 60(3*20) data points are obtained in total. For each data point, a bit (that is, NPᵢ ▪ sᵢ in Formula (4)) occupied by the data Vᵢ before compression is compared with a bit (that is, $\left({NP}_{i}-{E}_{reduce}^{i}\right) ⋅ {s}_{r} + \left({NP}_{i}-{E}_{reduce}^{i}\right) ⋅ {s}_{i}$ in Formula (4)) occupied by the data Vᵢ after compression, to calculate space that can be saved by performing RLE on the data Vᵢ, that is, the bit occupied by the data Vᵢ before compression - a quantity of bit occupied by the data Vᵢ after compression. When the space is a positive number, RLE may be used, so that deterioration does not occur in RLE.

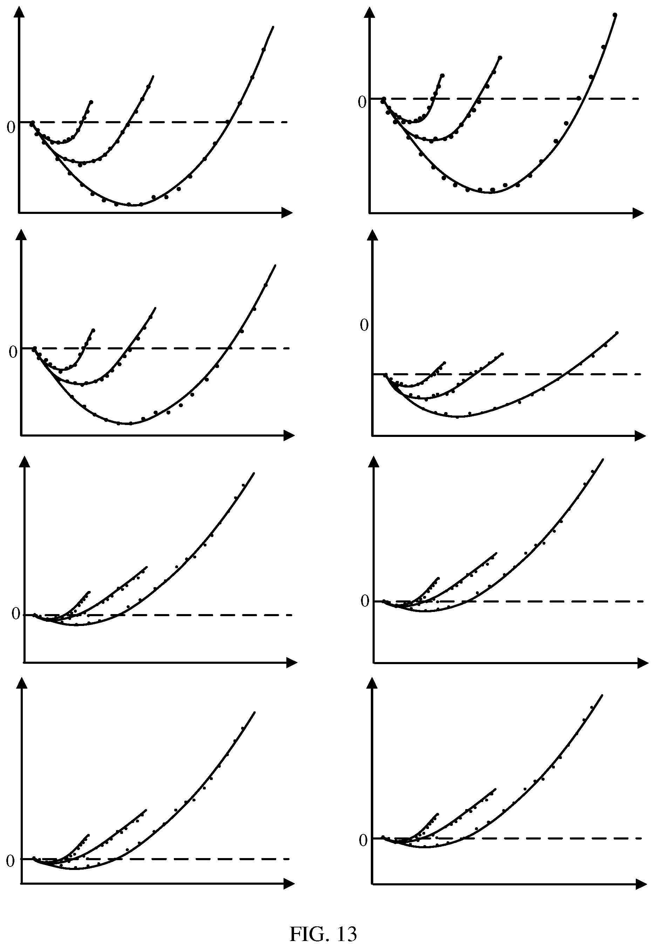

FIG. 13 shows a measured result corresponding to each group of sᵢ and sᵣ and a result obtained through calculation according to Formula (26). In FIG. 13, there are eight coordinate systems: coordinate systems sᵣ = 4 in a first column, coordinate systems sᵣ = 8 in a second column, coordinate systems sᵢ = 1 in a first row, coordinate systems sᵢ = 2 in a second row, coordinate systems sᵢ = 3 in a third row, and coordinate systems sᵢ = 4 in a fourth row. In addition, in each coordinate system in FIG. 13, a vertical axis indicates saved space, and a horizontal axis indicates bits occupied by data Vᵢ before compression. Levels of magnitudes of the vertical axes and the horizontal axes in different coordinate systems may vary slightly. Discrete points are measured results, continuous lines are results obtained through calculation according to Formula (26), and three lines in each coordinate system are sequentially corresponding to cases in which values of N are 1024, 2048, and 4096 from left to right. It can be easily seen that, in each group of sᵢ and sᵣ, both a measured result and a result obtained through calculation according to Formula (26) are fully consistent. This verifies correctness and availability of Formula (26).

Further, in comparison with a related technology in which sᵣ is usually set to a relatively large value, for example, 8 bits or 24 bits, in embodiments of this application, sᵣ is set to a relatively small value, for example, 4 bits, to ensure that more space is saved when RLE is performed on data. The saved space is negatively correlated with the value of sᵣ. A reason is as follows:

Formula (31) may be obtained by substituting Formula (26) into Formula (4): 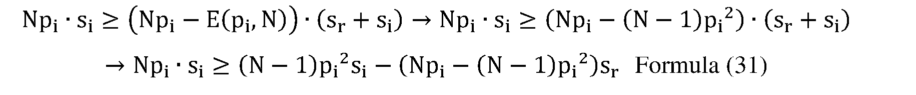 Npi ▪ si ≥ (Npi - E(pi, N)) ▪ (sr + si) → Npi ▪ si ≥ (Npi - (N - 1)pi2) ▪ (sr + si) → Npi ▪ si ≥ (N - 1)pi2si - (Npi - (N - 1)pi2)sr Formula (31)

Because Npᵢ is always an integer, Npᵢ - (N - 1)pᵢ² ≥ 0, so that a conclusion can be obtained: Within an allowed error range, the saved space is negatively correlated with the value of sᵣ.

In addition, Formula (31) continues to be transformed, as shown in Formula (32): ${s}_{r} \leq \frac{\left(N+1\right) {p}_{i}}{N - \left(N-1\right) {p}_{i}} ⋅ {s}_{i}$

Because N is large enough, N - 1 ≈ N ≈ N + 1. In this case, Formula (32) may be further simplified into Formula (33): ${s}_{r} \leq \frac{\left(N+1\right) {p}_{i}}{N - \left(N-1\right) {p}_{i}} ⋅ {s}_{i} = \frac{{Np}_{i}}{N - {Np}_{i}} ⋅ {s}_{i} = \frac{{N}_{i}}{N - {N}_{i}} ⋅ {s}_{i} \to {N}_{i} \geq \frac{{s}_{r}}{{s}_{i} + {s}_{r}} N$

Therefore, the derivation process is completed, and Formula (1) is obtained.

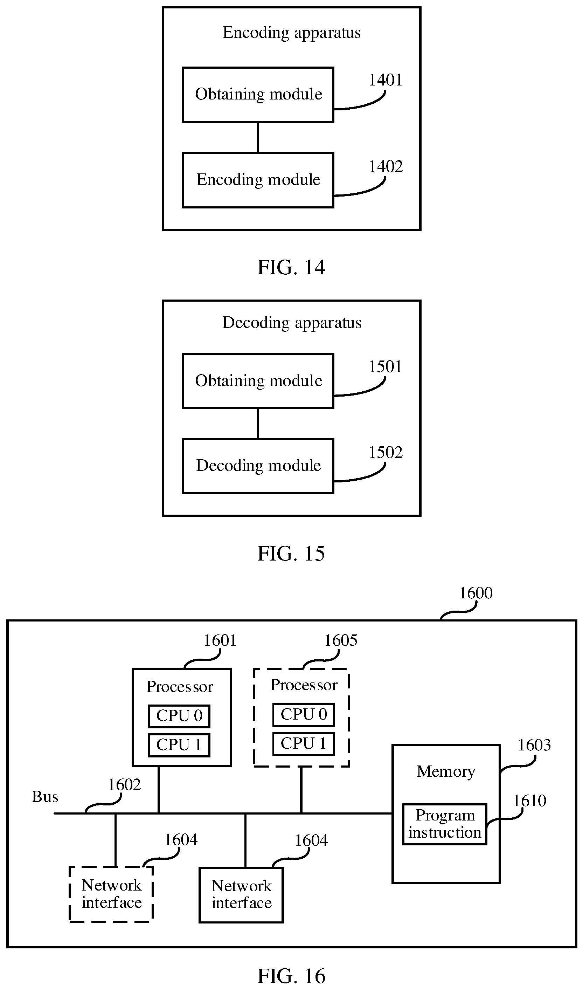

The foregoing describes the encoding method provided in embodiments of this application. Corresponding to the foregoing method, an embodiment of this application further provides an encoding apparatus. The apparatus is configured to perform, by using modules shown in FIG. 14, the encoding method shown in FIG. 2. As shown in FIG. 14, the encoding apparatus provided in this embodiment of this application includes the following modules:
an obtaining module 1401, configured to obtain a data set, where the data set includes N pieces of data, and N is greater than or equal to 2; and
an encoding module 1402, configured to: if an occurrence frequency of first data of the N pieces of data in the N pieces of data is greater than or equal to a reference threshold, perform RLE on the first data, where
the reference threshold is determined based on N, a bit occupied by a first element, and a bit occupied by a second element, the first element is determined based on the first data, and the second element is a consecutive occurrence count of the first data.

In a possible implementation, the reference threshold is determined based on a ratio of a first value to a second value, the first value is a product of the bit occupied by the second element and N, and the second value is a sum of the bit occupied by the first element and the bit occupied by the second element.

In a possible implementation, the encoding module 1402 is further configured to encode second data in the N pieces of data other than the first data, to obtain an encoding result, where the encoding result includes the first element, the second element, a third element, and a fourth element, the third element is determined based on the second data, an arrangement manner of the third element and the first element in the encoding result is the same as an arrangement manner of the second data and the first data in the N pieces of data, and the fourth element is determined based on the first data.

In a possible implementation, the encoding module 1402 is further configured to encode second data in the N pieces of data other than the first data, to obtain an encoding result, where the encoding result includes the first element, the second element, a fifth element, and a sixth element, the fifth element is determined based on the second data, and the sixth element indicates an arrangement manner of the second data and the first data in the N pieces of data.

In a possible implementation, the second element occupies 2^{M} bits, and M is greater than or equal to 1.

An embodiment of this application further provides a decoding apparatus. The apparatus is configured to perform, by using modules shown in FIG. 15, the decoding method shown in FIG. 8. As shown in FIG. 15, the decoding apparatus provided in this embodiment of this application includes the following modules:
an obtaining module 1501, configured to obtain an encoding result, where the encoding result is obtained by performing RLE on first data in N pieces of data included in a data set, N is greater than or equal to 2, an occurrence frequency of the first data in the N pieces of data is greater than or equal to a reference threshold, the reference threshold is determined based on N, a bit occupied by a first element, and a bit occupied by a second element, the first element is determined based on the first data, and the second element is a consecutive occurrence count of the first data; and
a decoding module 1502, configured to decode the encoding result.

In a possible implementation, the reference threshold is determined based on a ratio of a first value to a second value, the first value is a product of the bit occupied by the second element and N, and the second value is a sum of the bit occupied by the first element and the bit occupied by the second element.

In a possible implementation, the encoding result is further obtained by encoding second data in the N pieces of data other than the first data, the encoding result includes the first element, the second element, a third element, and a fourth element, the third element is determined based on the second data, an arrangement manner of the third element and the first element in the encoding result is the same as an arrangement manner of the second data and the first data in the N pieces of data, and the fourth element is determined based on the first data; and the decoding module 1502 is configured to decode the first element and the third element based on the second element and the fourth element.

In a possible implementation, the encoding result is further obtained by encoding second data in the N pieces of data other than the first data, the encoding result includes the first element, the second element, a fifth element, and a sixth element, the fifth element is determined based on the second data, and the sixth element indicates an arrangement manner of the second data and the first data in the N pieces of data; and the decoding module 1502 is configured to decode the first element and the fifth element based on the second element and the sixth element.

In a possible implementation, the second element occupies 2^{M} bits, and M is greater than or equal to 1.

When the apparatus shown in FIG. 14 implements functions of the apparatus, beneficial effects of the apparatus are the same as beneficial effects of the encoding method shown in FIG. 2. When the apparatus shown in FIG. 15 implements functions of the apparatus, beneficial effects of the apparatus are the same as beneficial effects of the decoding method shown in FIG. 8. When the apparatus provided in FIG. 14 or FIG. 15 implements the functions of the apparatus, division into the foregoing functional modules is merely used as an example for description. In actual application, the foregoing functions may be allocated and implemented by different functional modules based on requirements, that is, an internal structure of a device is divided into different functional modules, to implement all or a part of the foregoing described functions. In addition, the apparatus provided in the foregoing embodiments and the method embodiments belong to the same concept. For details of a specific implementation process, refer to the method embodiments. Details are not described herein again.

FIG. 16 is a diagram of a structure of an example computer device 1600 according to this application. The computer device 1600 includes at least one processor 1601, a memory 1603, and at least one network interface 1604.

The processor 1601 is, for example, a general-purpose central processing unit (central processing unit, CPU), a digital signal processor (digital signal processor, DSP), a network processor (network processor, NP), a graphics processing unit (graphics processing unit, GPU), a neural-network processing unit (neural-network processing unit, NPU), a data processing unit (data processing unit, DPU), a microprocessor or one or more integrated circuits or application-specific integrated circuits (application-specific integrated circuit, ASIC) configured to implement the solutions in this application, a programmable logic device (programmable logic device, PLD), another general-purpose processor or another programmable logic device, a discrete gate, a transistor logic device, a discrete hardware component, or any combination thereof. The PLD is, for example, a complex programmable logic device (complex programmable logic device, CPLD), a field-programmable gate array (field-programmable gate array, FPGA), a generic array logic (generic array logic, GAL), or any combination thereof. The general-purpose processor may be a microprocessor, any conventional processor, or the like. It should be noted that the processor may be a processor that supports an advanced reduced instruction set computer machines (advanced RISC machines, ARM) architecture. The processor may implement or execute various logical blocks, modules, and circuits described with reference to content disclosed in this application. Alternatively, the processor may be a combination implementing a computing function, for example, a combination including one or more microprocessors, or a combination of the DSP and the microprocessor.

Optionally, the computer device 1600 further includes a bus 1602. The bus 1602 is configured to transmit information between components of the computer device 1600. The bus 1602 may be a peripheral component interconnect (peripheral component interconnect, PCI for short) bus, an extended industry standard architecture (extended industry standard architecture, EISA for short) bus, or the like. The bus 1602 may be classified into an address bus, a data bus, a control bus, and the like. For ease of representation, the bus is represented by using only one line in FIG. 16, but it does not mean that there is only one bus or only one type of bus.

The memory 1603 is, for example, a volatile memory or a nonvolatile memory, or may include both a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache.

By way of example but not limitation, many forms of ROMs and RAMs are available. For example, the ROM is a compact disc read-only memory (compact disc read-only memory, CD-ROM). The RAM includes but is not limited to a static random access memory (static RAM, SRAM), a dynamic random access memory (dynamic random access memory, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), or a direct rambus random access memory (direct rambus RAM, DR RAM).

Alternatively, the memory 1603 may be another type of storage device that can store static information and instructions; or may be another type of dynamic storage device that can store information and instructions; or may be another compact disc storage, an optical disc storage (including a compact disc, a laser disc, an optical disc, a digital versatile disc, a Blu-ray disc, and the like), a magnetic disk storage medium, or another magnetic storage device, or any other medium that can be used to carry or store expected program code in a form of an instruction or a data structure and that can be accessed by a computer. The memory is not limited thereto. For example, the memory 1603 exists independently, and is connected to the processor 1601 through the bus 1602. Alternatively, the memory 1603 may be integrated with the processor 1601.

The network interface 1604 is configured to communicate with another device or a communication network through any transceiver-like apparatus. The communication network may be an Ethernet, a radio access network (radio access network, RAN), a wireless local area network (wireless local area network, WLAN), or the like. The network interface 1604 may include a wired network interface, and may further include a wireless network interface. Specifically, the network interface 1604 may be an Ethernet (Ethernet) interface, such as a fast Ethernet (fast Ethernet, FE) interface or a gigabit Ethernet (gigabit Ethernet, GE) interface, an asynchronous transfer mode (asynchronous transfer mode, ATM) interface, a WLAN interface, a cellular network interface, or a combination thereof. The Ethernet interface may be an optical interface, an electrical interface, or a combination thereof. In some implementations of this application, the network interface 1604 may be used by the computer device 1600 to communicate with another device.

During specific implementation, in some implementations, the processor 1601 may include one or more CPUs, for example, a CPU 0 and a CPU 1 shown in FIG. 16. Each of the processors may be a single-core processor or a multi-core processor. The processor herein may be one or more devices, circuits, and/or processing cores configured to process data (for example, computer program instructions).

During specific implementation, in some implementations, the computer device 1600 may include a plurality of processors, for example, the processor 1601 and a processor 1605 shown in FIG. 16. Each of the processors may be a single-core processor, or may be a multi-core processor. The processor herein may be one or more devices, circuits, and/or processing cores configured to process data (for example, computer program instructions).

In some implementations, the memory 1603 is configured to store program instructions 1610 for executing the solutions of this application, and the processor 1601 may execute the program instructions 1610 stored in the memory 1603. In other words, the computer device 1600 may implement, by using the processor 1601 and the program instructions 1610 in the memory 1603, the method provided in the method embodiment, that is, the encoding method shown in FIG. 2 or the decoding method shown in FIG. 8. The program instructions 1610 may include one or more software modules. Optionally, the processor 1601 may also store the program instructions for executing the solutions in this application.

In a specific implementation process, the computer device 1600 in this application may correspond to a product configured to perform the foregoing method, for example, an encoder or a decoder. The processor 1601 in the computer device 1600 reads instructions in the memory 1603, so that the computer device 1600 shown in FIG. 16 can perform all or a part of the steps in the method embodiments.

The computer device 1600 may further correspond to the apparatus shown in FIG. 14 or FIG. 15. Each functional module in the apparatus shown in FIG. 14 or FIG. 15 is implemented by software of the computer device 1600. In other words, the functional modules included in the apparatus shown in FIG. 14 or FIG. 15 are generated after the processor 1601 of the computer device 1600 reads the program instructions 1610 stored in the memory 1603.

Steps of the methods in FIG. 2 and FIG. 8 are completed by using an integrated logic circuit of hardware in a processor of the computer device 1600, or by using instructions in a form of software. The steps in the method embodiments disclosed with reference to this application may be directly performed and completed by a hardware processor, or may be performed and completed by using a combination of hardware in the processor and a software module. A software module may be located in a mature storage medium in the art, such as a random access memory, a flash memory, a read-only memory, a programmable read-only memory, an electrically erasable programmable memory, or a register. The storage medium is located in the memory, and the processor reads information in the memory, and completes the steps in the method embodiments in combination with hardware of the processor. To avoid repetition, details are not described herein again.

An embodiment of this application provides a computer device. The device includes a memory and a processor. The memory stores at least one computer instruction, and the at least one computer instruction is loaded and executed by the processor, so that the computer device implements the encoding method shown in FIG. 2 or the decoding method shown in FIG. 8.

An embodiment of this application provides an encoding and decoding system. The system includes an encoder and a decoder. The encoder is configured to perform the encoding method shown in FIG. 2, and the decoder is configured to perform the decoding method shown in FIG. 8.

For example, an embodiment of this application provides a computer program or a computer program product. The computer program or the computer program product includes computer instructions. When the computer instructions are run by a computer, the computer is enabled to implement the encoding method shown in FIG. 2 or the decoding method shown in FIG. 8.

An embodiment of this application provides a computer-readable storage medium. The computer-readable storage medium stores computer instructions. When the computer instructions are run on a computer, the computer performs the encoding method shown in FIG. 2 or the decoding method shown in FIG. 8.

In an example embodiment, an embodiment of this application provides a chip, including a processor, configured to invoke, from a memory, and run instructions stored in the memory, so that a computer in which the chip is installed performs the encoding method shown in FIG. 2 or the decoding method shown in FIG. 8.

An embodiment of this application further provides another chip, including an input interface, an output interface, a processor, and a memory. The input interface, the output interface, the processor, and the memory are connected through an internal connection path. The processor is configured to execute code in the memory. When the code is executed, a computer in which the chip is installed performs the encoding method shown in FIG. 2 or the decoding method shown in FIG. 8.

All or a part of the foregoing embodiments may be implemented by software, hardware, firmware, or any combination thereof. When software is used to implement the embodiments, all or a part of the embodiments may be implemented in a form of a computer program product. The computer program product includes one or more computer instructions. When the computer program instructions are loaded and executed on the computer, the procedure or functions according to this application are all or partially generated. The computer may be a general-purpose computer, a dedicated computer, a computer network, or other programmable apparatuses. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk, or a magnetic tape), an optical medium (for example, DVD), a semiconductor medium (for example, a solid state disk (solid state disk)), or the like.

In this application, terms such as "first" and "second" are used to distinguish between same items or similar items that have basically same functions. It should be understood that there is no logical or time sequence dependency between "first", "second", and "n^{th}", and a quantity and an execution sequence are not limited. It should also be understood that although the following descriptions use terms such as "first" and "second" to describe various elements, these elements should not be limited by the terms. These terms are simply used to distinguish one element from another element.

It should be further understood that sequence numbers of the processes do not mean execution sequences in embodiments of this application. The execution sequences of the processes should be determined based on functions and internal logic of the processes, and should not constitute any limitation on implementation processes of embodiments of this application.

The term "at least one" in this application means one or more, and the term "a plurality of" in this application means two or more. For example, a plurality of pieces of data mean two or more pieces of data. The terms "system" and "network" are often used interchangeably herein.

It should be understood that the terms used in the descriptions of the various examples herein are merely intended to describe specific examples and are not intended to impose a limitation. The terms "one" ("a" and "an") and "the" of singular forms used in the descriptions of various examples and the appended claims are also intended to include plural forms, unless otherwise specified in the context clearly.

It should further be understood that the term "and/or" used in this specification indicates and includes any or all possible combinations of one or more of the associated listed items. The term "and/or" describes an association relationship for describing associated objects and represents that three relationships may exist. For example, A and/or B may represent the following three cases: Only A exists, both A and B exist, and only B exists. In addition, the character "/" in this application generally indicates an "or" relationship between the associated objects.

It should be further understood that the terms "if" and "if" may be interpreted to mean "when" ("when" or "upon") or "in response to determining" or "in response to detecting". Similarly, according to the context, the phrase "if it is determined that" or "if (a stated condition or event) is detected" may be interpreted as a meaning of "when it is determined that" or "in response to determining" or "when (a stated condition or event) is detected" or "in response to detecting (a stated condition or event)".

The foregoing descriptions are embodiments of this application, but are not intended to limit this application. Any modification, equivalent replacement, improvement, or the like made without departing from the principle of this application should fall within the protection scope of this application.

## Claims

1. An encoding method, wherein the method comprises:
obtaining a data set, wherein the data set comprises N pieces of data, and N is greater than or equal to 2; and
if an occurrence frequency of first data of the N pieces of data in the N pieces of data is greater than or equal to a reference threshold, performing run-length encoding RLE on the first data, wherein
the reference threshold is determined based on N, a quantity of bits occupied by a first element, and a quantity of bit occupied by a second element, the first element is determined based on the first data, and the second element is a consecutive occurrence count of the first data.

2. The method according to claim 1, wherein the reference threshold is determined based on a ratio of a first value to a second value, the first value is a product of the quantity of bit occupied by the second element and N, and the second value is a sum of the quantity of bit occupied by the first element and the quantity of bit occupied by the second element.

3. The method according to claim 1 or 2, wherein the method further comprises:
encoding second data in the N pieces of data other than the first data, to obtain an encoding result, wherein
the encoding result comprises the first element, the second element, a third element, and a fourth element, the third element is determined based on the second data, an arrangement manner of the third element and the first element in the encoding result is the same as an arrangement manner of the second data and the first data in the N pieces of data, and the fourth element is determined based on the first data.

4. The method according to claim 1 or 2, wherein the method further comprises:
encoding second data in the N pieces of data other than the first data, to obtain an encoding result, wherein
the encoding result comprises the first element, the second element, a fifth element, and a sixth element, the fifth element is determined based on the second data, and the sixth element indicates an arrangement manner of the second data and the first data in the N pieces of data.

5. The method according to any one of claims 1 to 4, wherein the second element occupies 2^{M} bits, and M is greater than or equal to 1.

6. A decoding method, wherein the method comprises:
obtaining an encoding result, wherein the encoding result is obtained by performing run-length encoding RLE on first data in N pieces of data comprised in a data set, N is greater than or equal to 2, an occurrence frequency of the first data in the N pieces of data is greater than or equal to a reference threshold, the reference threshold is determined based on N, a quantity of bit occupied by a first element, and a quantity of bit occupied by a second element, the first element is determined based on the first data, and the second element is a consecutive occurrence count of the first data; and
decoding the encoding result.

7. The method according to claim 6, wherein the reference threshold is determined based on a ratio of a first value to a second value, the first value is a product of the quantity of bit occupied by the second element and N, and the second value is a sum of the quantity of bit occupied by the first element and the quantity of bit occupied by the second element.

8. The method according to claim 6 or 7, wherein the encoding result is further obtained by encoding second data in the N pieces of data other than the first data, the encoding result comprises the first element, the second element, a third element, and a fourth element, the third element is determined based on the second data, an arrangement manner of the third element and the first element in the encoding result is the same as an arrangement manner of the second data and the first data in the N pieces of data, and the fourth element is determined based on the first data; and
the decoding the encoding result comprises:
decoding the first element and the third element based on the second element and the fourth element.

9. The method according to claim 6 or 7, wherein the encoding result is further obtained by encoding second data in the N pieces of data other than the first data, the encoding result comprises the first element, the second element, a fifth element, and a sixth element, the fifth element is determined based on the second data, and the sixth element indicates an arrangement manner of the second data and the first data in the N pieces of data; and
the decoding the encoding result comprises:
decoding the first element and the fifth element based on the second element and the sixth element.

10. The method according to any one of claims 6 to 9, wherein the second element occupies 2^{M} bits, and M is greater than or equal to 1.

11. An encoding apparatus, wherein the apparatus comprises:
an obtaining module, configured to obtain a data set, wherein the data set comprises N pieces of data, and N is greater than or equal to 2; and
an encoding module, configured to: if an occurrence frequency of first data of the N pieces of data in the N pieces of data is greater than or equal to a reference threshold, perform run-length encoding RLE on the first data, wherein
the reference threshold is determined based on N, a quantity of bit occupied by a first element, and a quantity of bit occupied by a second element, the first element is determined based on the first data, and the second element is a consecutive occurrence count of the first data.

12. The apparatus according to claim 11, wherein the reference threshold is determined based on a ratio of a first value to a second value, the first value is a product of the quantity of bit occupied by the second element and N, and the second value is a sum of the quantity of bit occupied by the first element and the quantity of bit occupied by the second element.

13. The apparatus according to claim 11 or 12, wherein the encoding module is further configured to encode second data in the N pieces of data other than the first data, to obtain an encoding result, wherein
the encoding result comprises the first element, the second element, a third element, and a fourth element, the third element is determined based on the second data, an arrangement manner of the third element and the first element in the encoding result is the same as an arrangement manner of the second data and the first data in the N pieces of data, and the fourth element is determined based on the first data.

14. The apparatus according to claim 11 or 12, wherein the encoding module is further configured to encode second data in the N pieces of data other than the first data, to obtain an encoding result, wherein
the encoding result comprises the first element, the second element, a fifth element, and a sixth element, the fifth element is determined based on the second data, and the sixth element indicates an arrangement manner of the second data and the first data in the N pieces of data.

15. The apparatus according to any one of claims 11 to 14, wherein the second element occupies 2^{M} bits, and M is greater than or equal to 1.

16. A decoding apparatus, wherein the apparatus comprises:
an obtaining module, configured to obtain an encoding result, wherein the encoding result is obtained by performing run-length encoding RLE on first data in N pieces of data comprised in a data set, N is greater than or equal to 2, an occurrence frequency of the first data in the N pieces of data is greater than or equal to a reference threshold, the reference threshold is determined based on N, a quantity of bit occupied by a first element, and a quantity of bit occupied by a second element, the first element is determined based on the first data, and the second element is a consecutive occurrence count of the first data; and
a decoding module, configured to decode the encoding result.

17. The apparatus according to claim 16, wherein the reference threshold is determined based on a ratio of a first value to a second value, the first value is a product of the quantity of bit occupied by the second element and N, and the second value is a sum of the quantity of bit occupied by the first element and the quantity of bit occupied by the second element.

18. The apparatus according to claim 16 or 17, wherein the encoding result is further obtained by encoding second data in the N pieces of data other than the first data, the encoding result comprises the first element, the second element, a third element, and a fourth element, the third element is determined based on the second data, an arrangement manner of the third element and the first element in the encoding result is the same as an arrangement manner of the second data and the first data in the N pieces of data, and the fourth element is determined based on the first data; and
the decoding module is configured to decode the first element and the third element based on the second element and the fourth element.

19. The apparatus according to claim 16 or 17, wherein the encoding result is further obtained by encoding second data in the N pieces of data other than the first data, the encoding result comprises the first element, the second element, a fifth element, and a sixth element, the fifth element is determined based on the second data, and the sixth element indicates an arrangement manner of the second data and the first data in the N pieces of data; and
the decoding module is configured to decode the first element and the fifth element based on the second element and the sixth element.

20. The apparatus according to any one of claims 16 to 19, wherein the second element occupies 2^{M} bits, and M is greater than or equal to 1.

21. A computer device, wherein the computer device comprises a memory and a processor, the memory stores at least one computer instruction, and the at least one computer instruction is loaded and executed by the processor, so that the computer device implements the encoding method according to any one of claims 1 to 5 or the decoding method according to any one of claims 6 to 10.

22. A computer-readable storage medium, wherein the computer-readable storage medium stores at least one computer instruction, and the at least one computer instruction is loaded and executed by a processor, so that a computer device implements the encoding method according to any one of claims 1 to 5 or the decoding method according to any one of claims 6 to 10.

23. A computer program product, wherein the computer program product comprises computer instructions, and the computer instructions are executed by a processor, so that a computer device implements the encoding method according to any one of claims 1 to 5 or the decoding method according to any one of claims 6 to 10.
